# EUROPÄISCHE PATENTSCHRIFT

(11) **EP 0 787 255 B1**
(45) Veröffentlichungstag und Bekanntmachung des Hinweises auf die Patenterteilung: **31.07.2002**
(21) Anmeldenummer: 96907267.7
(22) Anmeldetag: 23.03.1996
(51) Int. Cl.: F02M 61/18, B05B 1/34, F02M 61/16, F02M 51/06, C25D 1/10

(54) **LOCHSCHEIBE, INBESONDERE FÜR EINSPRITZVENTILE**
PERFORATED DISC, ESPECIALLY FOR INJECTION VALVES
DISQUE PERFORE, NOTAMMENT POUR SOUPAPES D'INJECTION

(30) Priorität: 29.03.1995 DE 19511540; 27.02.1996 DE 19607266
(43) Veröffentlichungstag der Anmeldung: 06.08.1997
(60) Teilanmeldung: 01127970.0
(73) Patentinhaber: ROBERT BOSCH GMBH, 70442 Stuttgart (DE)
(72) Erfinder: ARNDT, Stefan, D-70569 Stuttgart (DE); HAHN, Dietmar, D-70839 Gerlingen (DE); FUCHS, Heinz, D-70469 Stuttgart (DE); FLIK, Gottfried, D-71229 Leonberg (DE); DANTES, Günter, D-71735 Eberdingen (DE); MÖRSCH, Gilbert, D-70563 Stuttgart (DE); NOWAK, Detlef, D-70435 Stuttgart (DE); HEYSE, Jörg, D-71706 Markgröningen (DE); WALZ, Beate, D-70499 Stuttgart (DE); SCHATZ, Frank, D-70806 Kornwestheim (DE)
(86) Internationale Anmeldenummer: DE9600511
(87) Internationale Veröffentlichungsnummer: WO9630644

(56) Entgegenhaltungen:
- EP-A- 0 354 660
- EP-A- 0 611 886
- DE-A- 4 331 851
- JP-A- 4 323 393
- US-A- 5 207 865
- US-A- 5 383 597
- PATENT ABSTRACTS OF JAPAN vol. 5, no. 54 (C-050), 15.April 1981 & JP,A,56 005979 (RICOH CO LTD), 22.Januar 1981,

## Beschreibung

### Stand der Technik

Die Erfindung geht aus von einer Lochscheibe, insbesondere für Einspritzventile, nach dem Oberbegriff des Anspruchs 1.

Es ist bereits aus der EP-OS 0 354 660 bekannt, Düsen in Lochscheibenform zu fertigen, die sogenannte "S-Typ-Scheiben" darstellen. Damit ist gemeint, daß die Ein- und die Auslaßöffnungen in der Lochscheibe zueinander versetzt ausgebildet sind, wodurch sich zwangsläufig ein "S-Schlag" in der Strömung eines die Lochscheibe durchströmenden Fluids ergibt. Die vorgeschlagenen Lochscheiben werden von zwei ebenen, durch Bonden zusammengefügten Plättchen gebildet, die aus Silizium bestehen. An den Siliziumplättchen sind Bereiche reduzierter Dicke ausgeformt, so daß Scherspalte parallel zu den Stirnflächen der Plättchen zwischen den Öffnungen des ersten Plättchens und der einen Öffnung des zweiten Plättchens gebildet sind. Mit der bekannten Maskentechnik werden durch Ätzen auf Siliziumwafern, die eine Vielzahl von Lochscheibenstrukturen aufweisen, die Ein- und Auslaßöffnungen erzeugt. Die kegelstumpfförmigen Konturen für die Öffnungen in der Lochscheibe ergeben sich in logischer Weise aus der anisotropen Ätztechnik.

Eine Ventilanordnung, bestehend aus einem elastischen Siliziumventilplättchen und einem Düsenplättchen ebenfalls aus Silizium, ist schon aus der EP-OS 0 314 285 bekannt. Die beiden Siliziumplättchen sind miteinander verbunden und können relativ zueinander ausgelenkt werden. Im Siliziumventilplättchen sind Einlaßöffnungen vorgesehen, die mit einem Versatz zu Auslaßöffnungen im Düsenplättchen angeordnet sind. Im geschlossenen Zustand der Ventilanordnung dichten Plateauflächen des Siliziumventilplättchens die Auslaßöffnungen im Düsenplättchen ab, während bei einem Verbiegen des Düsenplättchens mittels eines Betätigungsgliedes ein S-förmiger Durchgang für ein Fluid entsteht und die Ventilanordnung geöffnet ist.

Aus der US-PS 4 907 748 ist bereits ein Brennstoffeinspritzventil bekannt, das an seinem stromabwärtigen Ende eine aus zwei Siliziumplättchen bestehende Düse aufweist. Ähnlich wie bei den oben beschriebenen Lochscheiben weisen die Ein- und Auslaßöffnungen in den beiden Siliziumplättchen zueinander Versätze auf, so daß ein "S-Schlag" in der Strömung eines durchströmenden Fluids, hier Brennstoff, entsteht.

Alle vorgenannten Lochscheiben aus Silizium besitzen den Nachteil einer eventuell nicht ausreichenden Bruchfestigkeit, die sich durch die Sprödigkeit von Silizium ergibt. Gerade bei Dauerbelastungen z. B. an einem Einspritzventil (Motorschwingungen) besteht die Gefahr, daß die Siliziumplättchen brechen. Die Montage der Siliziumplättchen an metallischen Bauteilen, wie beispielsweise an Einspritzventilen, ist aufwendig, da besondere spannungsfreie Klemmlösungen gefunden werden müssen und die Abdichtung am Ventil problematisch ist. Ein Anschweißen der Lochscheiben aus Silizium am Einspritzventil ist z. B. nicht möglich. Außerdem besteht der Nachteil einer Kantenabnutzung an den Öffnungen der Siliziumscheiben beim oftmaligen Durchströmen mit einem Fluid.

Des weiteren ist bereits aus der DE-PS 483 615 eine Düse für Einspritzbrennkraftmaschinen bekannt, die ebenfalls aus zwei Düsenplättchen gebildet ist, wobei die Düsenplättchen zueinander versetzt angeordnete Ein- und Auslaßöffnungen aufweisen, um ein Zerreißen des durchfließenden Brennstoffs zu begünstigen. Mit dieser Düse ist jedoch in keiner Weise eine Formung des abgespritzten Brennstoffs entsprechend einer gewünschten Geometrie möglich.

Bekannt ist bereits aus der JP 4 323 393 A eine Lochscheibe bestehend aus zwei Plättchen, die mittels galvanischer Metallabscheidung hergestellt werden, wobei die Anwendung dieses Verfahrens jedoch einzeln für jede Schicht/Platte zur Anwendung kommt. Während eine untere Platte mittels galvanischer Metallabscheidung hergestellt wird, kommen für die Herstellung einer oberen Platte ein Ätzen oder die galvanische Metallabscheidung in Frage. Jede einzelne strukturierte Platte liegt separat gefertigt als Einzelbauteil vor. Nachfolgend werden die beiden Metallplatten miteinander durch Diffusion verbunden, um eine gewünschte Lochscheibe zu ergeben. Die Platten werden mit ihren Öffnungen exakt derart aufeinander gebracht, dass diese genau zueinander fluchten und somit von einer oberen bis zu einer unteren Stirnfläche der Lochscheibe jeweils Durchgangsöffnungen bilden. Ein Versatz von Einlass und Auslass der Lochscheibe ist auf diese Weise nicht darstellbar.

### Vorteile der Erfindung

Die erfindungsgemäße Lochscheibe mit den kennzeichnenden Merkmalen des Anspruchs 1 hat den Vorteil, daß eine gleichmäßige Feinstzerstäubung eines Fluids ohne Zusatzenergie, also nur über den verfügbaren Mediumdruck, erreicht wird, wobei eine besonders hohe Zerstäubungsgüte und eine an die jeweiligen Erfordernisse angepaßte Strahlformung erzielt wird. Als Konsequenz können bei Verwendung einer solchen Lochscheibe an einem Einspritzventil einer Brennkraftmaschine unter anderem die Abgasemission der Brennkraftmaschine reduziert und ebenso eine Verringerung des Brennstoffverbrauchs erzielt werden.

So können mit den erfindungsgemäßen Lochscheiben in der Form von S-Typ-Scheiben exotische, bizarre Strahlformen erzeugt werden. Diese Lochscheiben ermöglichen für Ein-, Zwei- und Mehrstrahlsprays Strahlquerschnitte in unzähligen Varianten, wie z. B. Rechtecke, Dreiecke, Kreuze, Ellipsen. Solche ungewöhnlichen Strahlformen erlauben eine genaue optimale Anpassung an vorgegebene Geometrien, z. B. an verschiedene Saugrohrquerschnitte von Brennkraftmaschinen. Daraus ergeben sich die Vorteile einer formangepaßten Ausnutzung des verfügbaren Querschnitts zur homogen verteilten, abgasmindernden Gemischeinbringung und einer Vermeidung von abgasschädlichen Wandfilmanlagerungen an der Saugrohrwandung.

Durch die in den Unteransprüchen aufgeführten Maßnahmen sind vorteilhafte Weiterbildungen und Verbesserungen der im Anspruch 1 angegebenen Lochscheibe möglich.

Besonders vorteilhaft ist es, die als Strömungsverbindungen von Ein- und Auslaßöffnungen ausgebildeten Kanäle mit Kanalfortsätzen (cavities) vorzusehen, in denen durch das vorbeiströmende Fluid Strömungswirbel angetrieben werden. Die Wechselwirkung zwischen dem Wirbel und der antreibenden Strömung führt zu zeitlichen Instabilitäten im Wechselwirkungsgebiet. Die Strömung wird zwangsläufig zu Schwingungen angeregt, wodurch zum einen eigenwillige Strahlbilder erzeugbar sind und zum anderen aber auch die resultierende Turbulenz zu einer Reduzierung der mittleren Tröpfchendurchmesser im Spray führt.

Ein weiterer Vorteil ergibt sich durch den Einsatz einer Stolperfalle in der Lochscheibe. Im Nachlauf einer solchen Stolperfalle entsteht eine Wirbelschleppe mit starken Querimpulsen. Die Turbulenz in der Wirbelschleppe trägt dazu bei, daß ein homogenes Spray mit sehr feinen Tröpfchen abgespritzt wird. Die Folge der vorteilhaften Reduzierung des mittleren Tröpfchendurchmessers im Spray ist eine homogene Sprayverteilung. Ursache ist die wegen des homogenen Sprays resultierende geringere Tröpfchenverteilungsdichte. Daraus resultiert eine herabgesetzte Wahrscheinlichkeit von Tröpfchenkoagulationen.

Weitere Vorteile sind bei der Beschreibung der Ausführungsbeispiele erwähnt.

Die Verfahrensschritte der galvanischen Metallabscheidung erlauben eine extrem große Gestaltungsfreiheit, da die Konturen der Öffnungen in der Lochscheibe frei wählbar sind. In vorteilhafter Weise werden dabei Verfahren, wie die UV-Tiefenlithographie, das Trockenätzen oder das Ablatieren mit einer Mikrogalvanik kombiniert, um dünne metallische Schichten mit immer neuen Strukturen aufeinander abzuscheiden. Dieser Prozeß ist geeignet, um zwei, drei oder mehr Schichten für eine Lochscheibe aufzubauen.

Besonders vorteilhaft ist es, wenigstens eine zwei Ebenen bzw. Funktionsebenen umfassende Schicht der Lochscheibe in einem Galvanikschritt aufzubauen, wobei das sogenannte "laterale Überwachsen" der Galvanik zur Anwendung kommt. Dabei wird ohne zusätzliches Aufbringen einer Galvanikstartschicht und einer neuen Schicht Photoresists das Wachsen des Metalls gezielt über die Photoresiststruktur der vorhergehenden Ebene fortgesetzt. Mit Hilfe des "lateralen Überwachsens" wird eine deutliche Kosten- und Zeitersparnis erreicht.

### Zeichnung

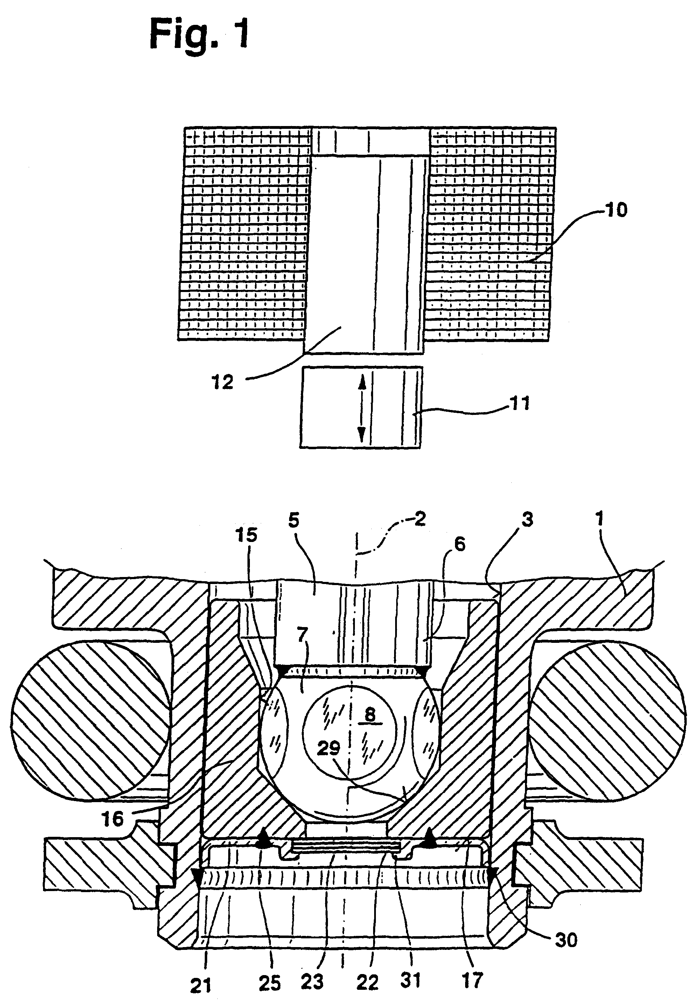

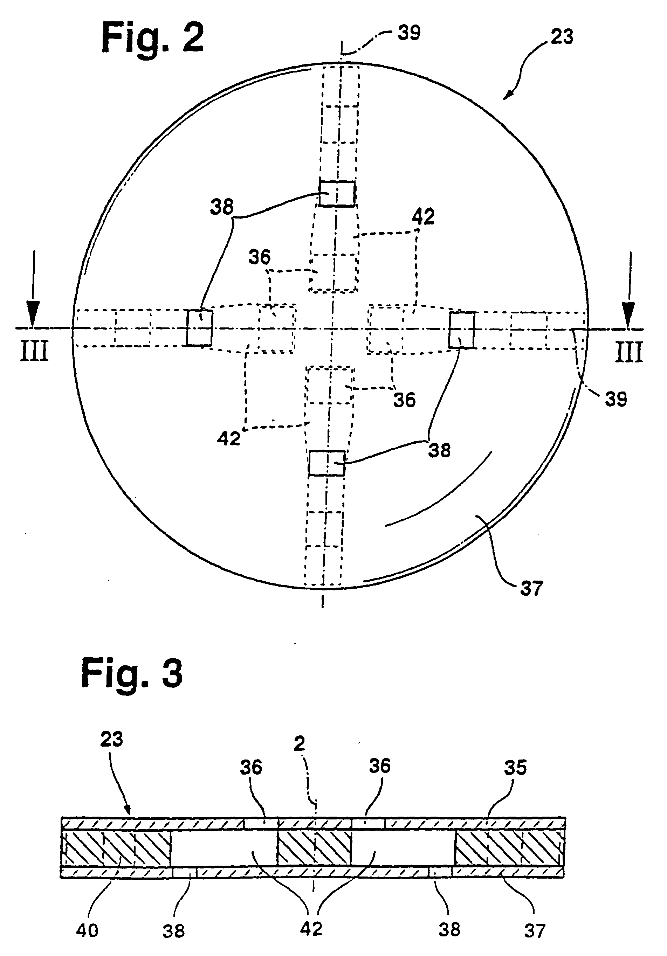

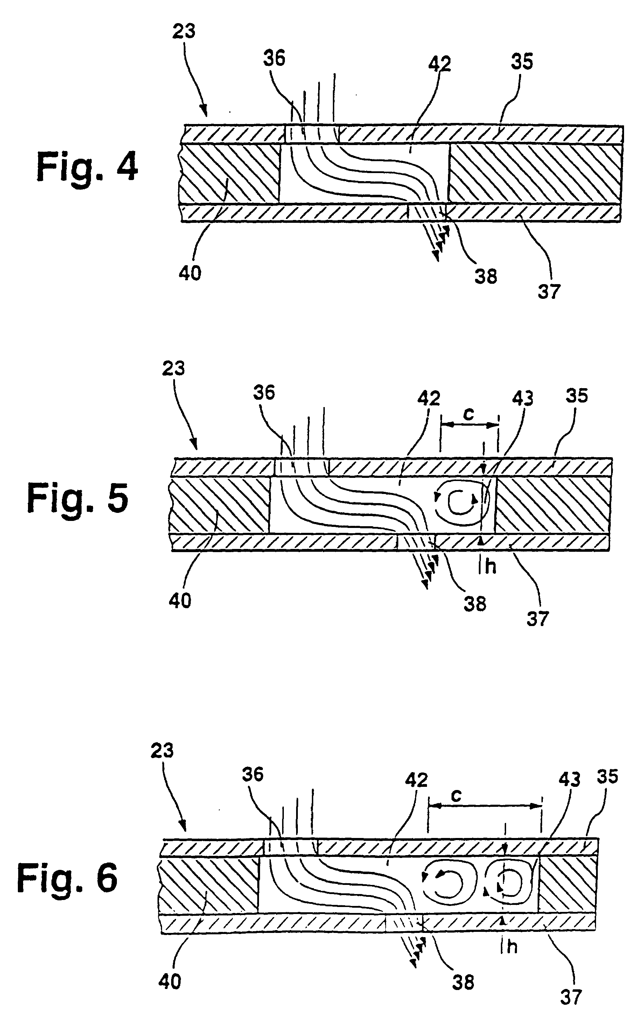

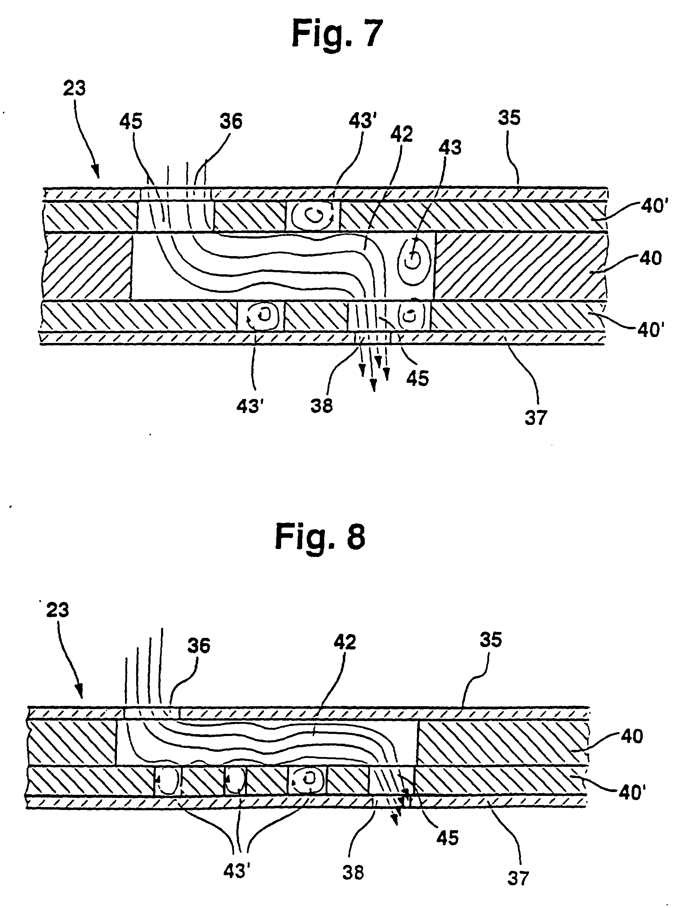

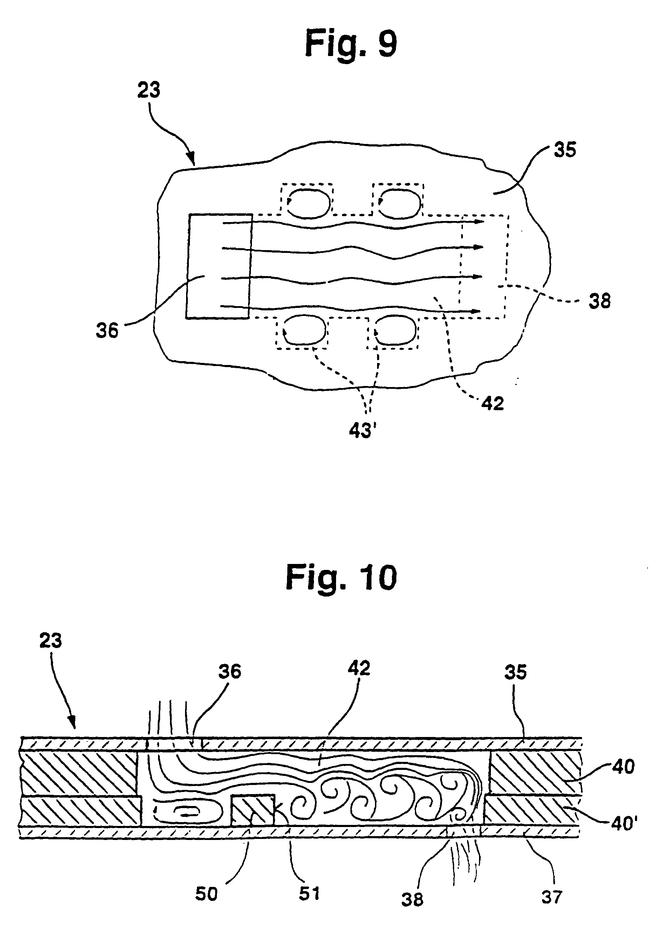

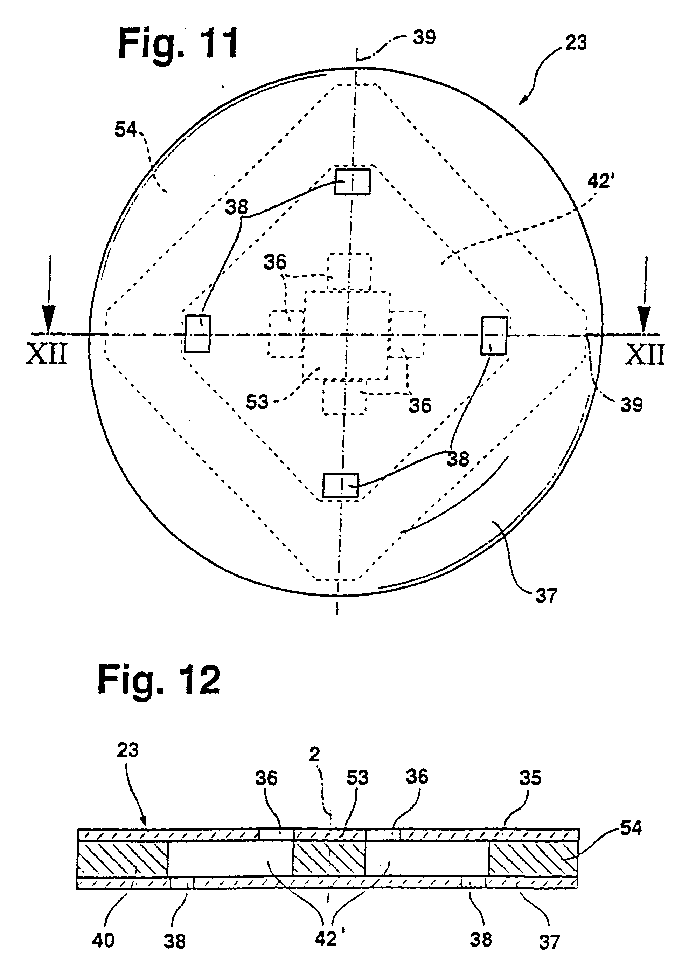

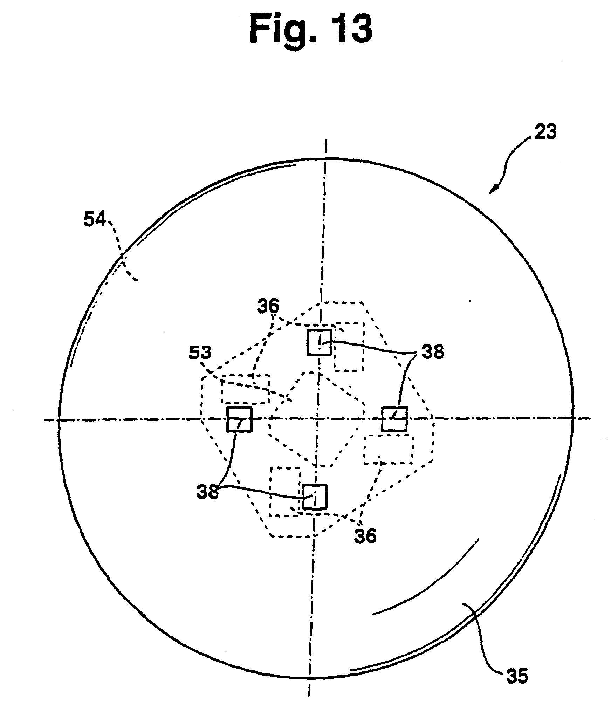

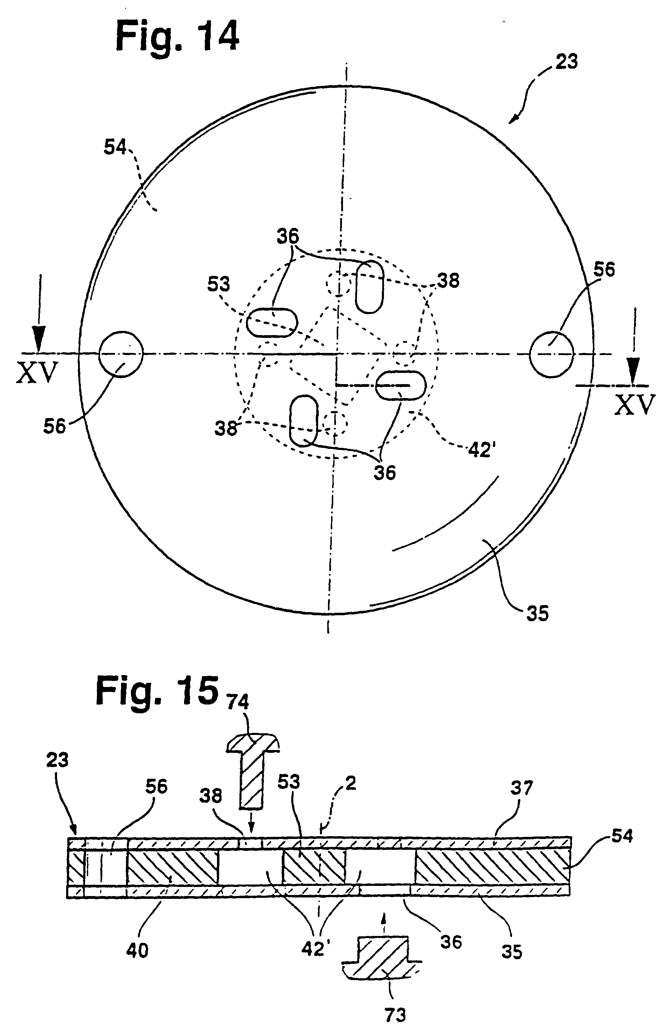

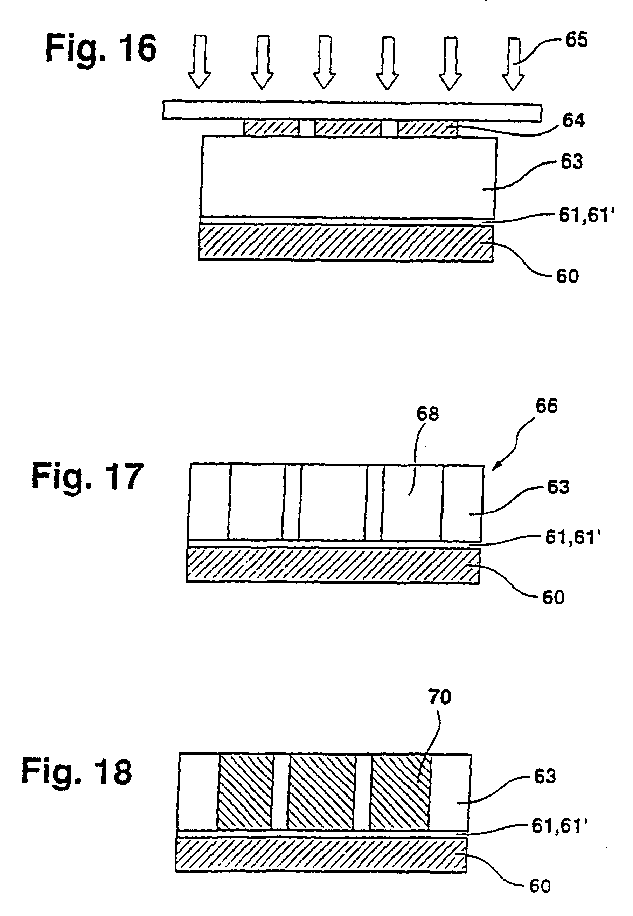

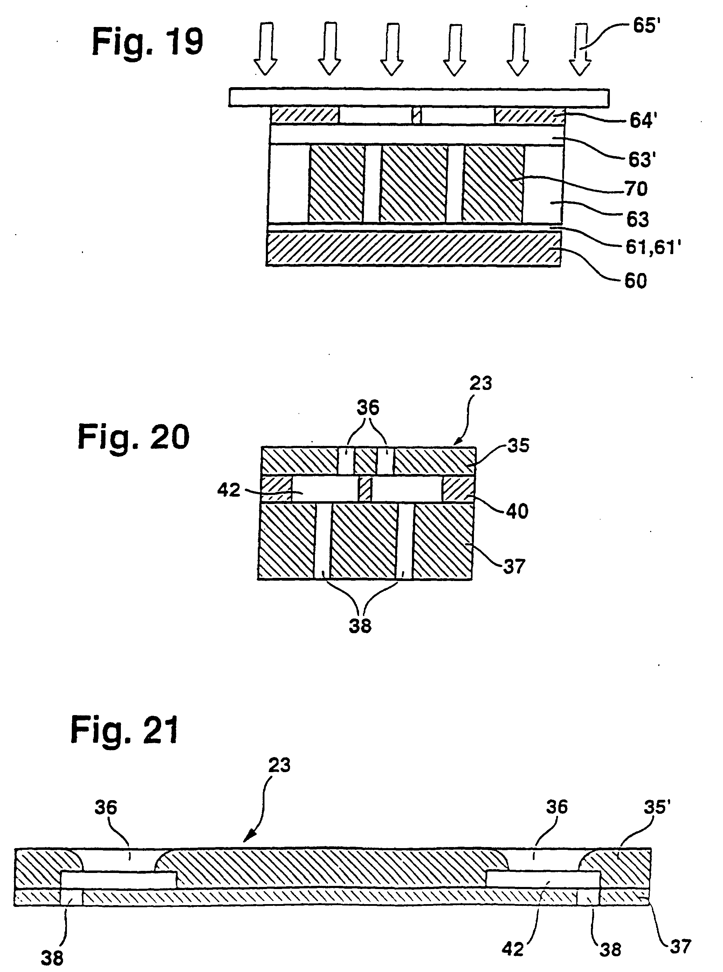

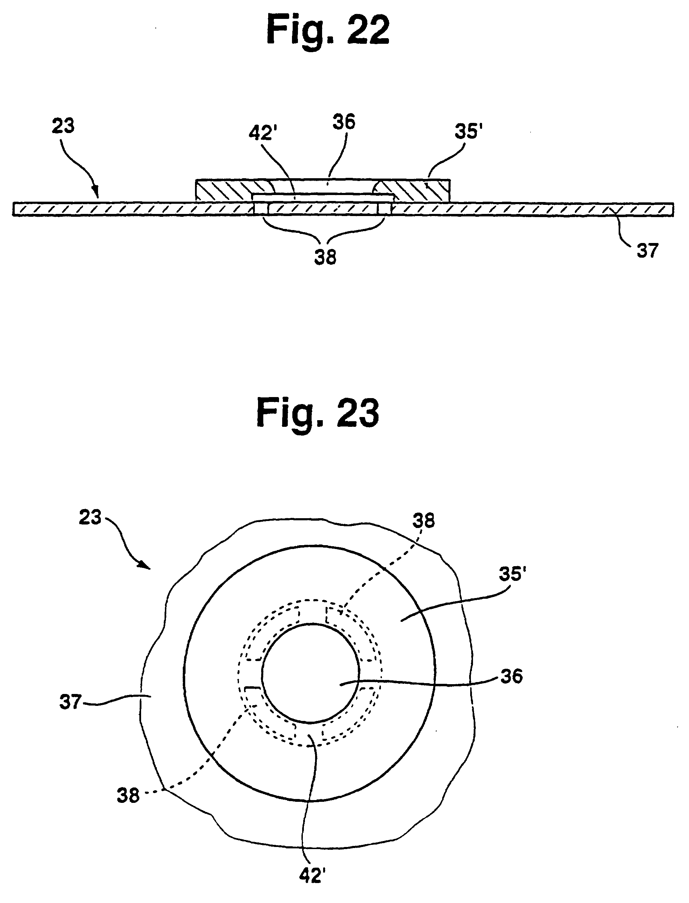

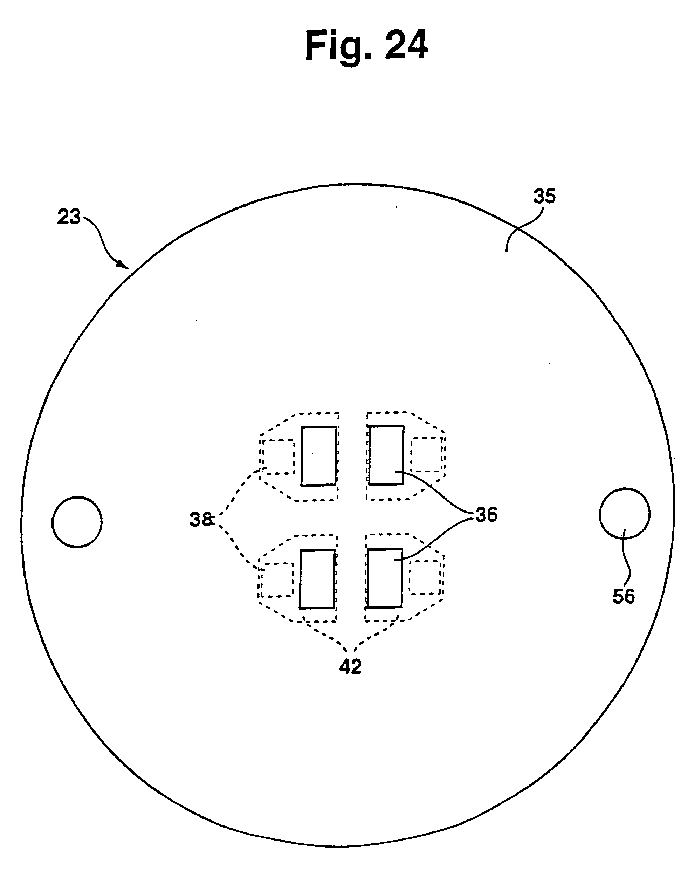

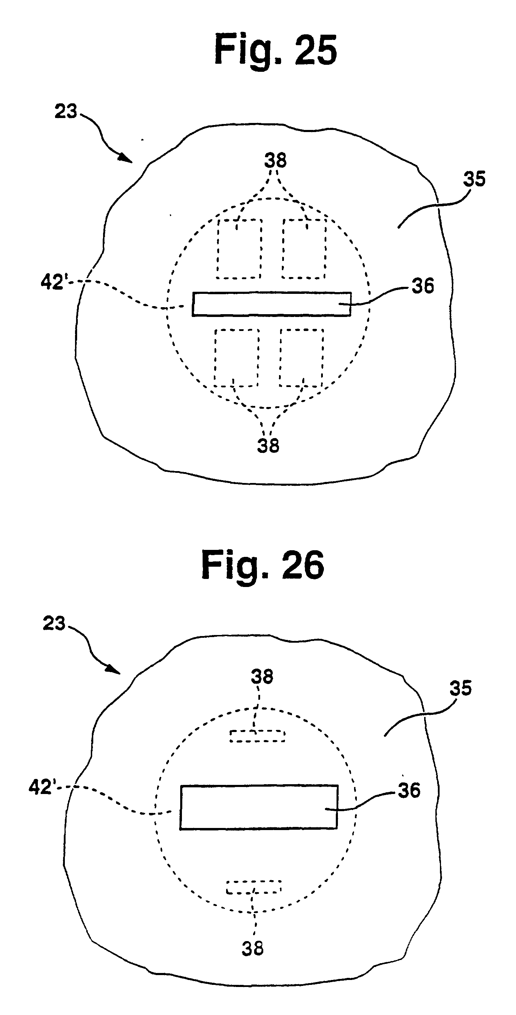

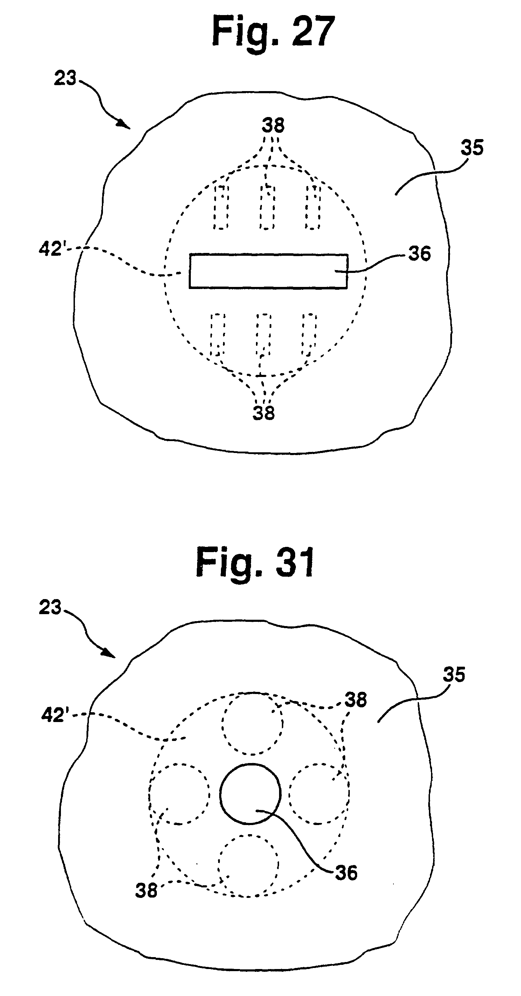

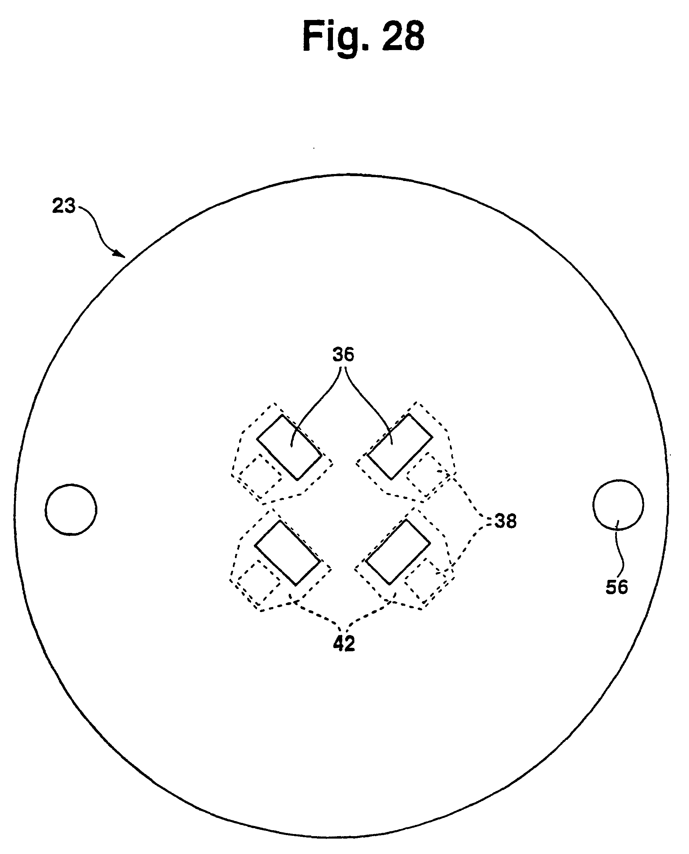

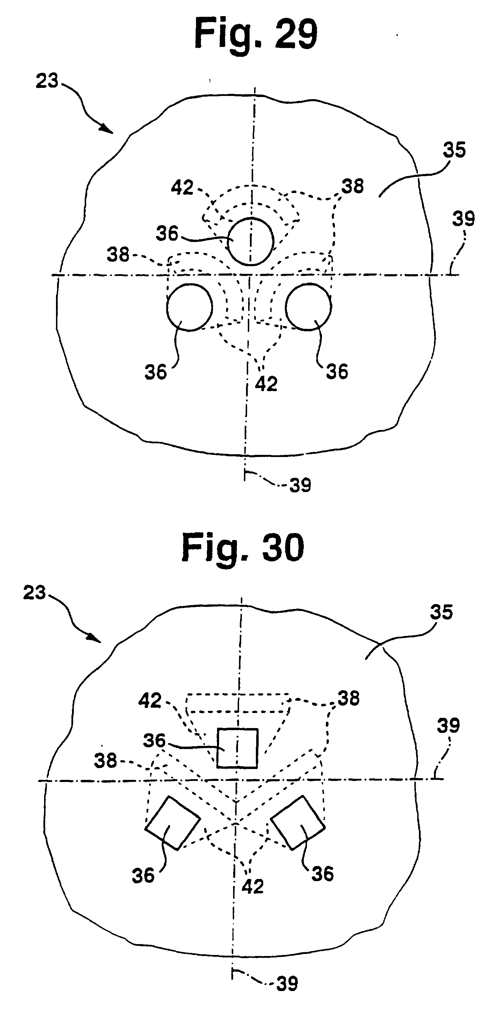

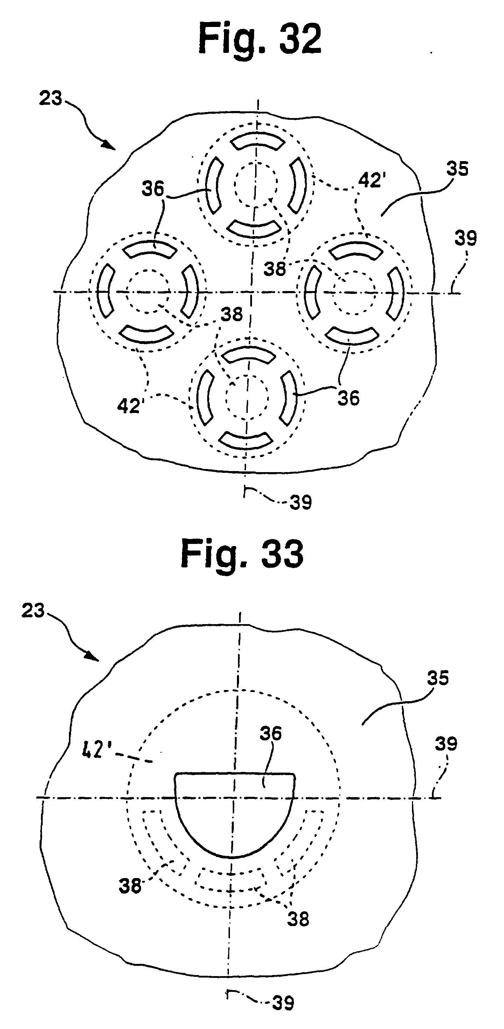

Ausführungsbeispiele der Erfindung sind in der Zeichnung vereinfacht dargestellt und in der nachfolgenden Beschreibung näher erläutert. Es zeigen Figur 1 ein teilweise dargestelltes Einspritzventil mit einer erfindungsgemäßen Lochscheibe, Figur 2 eine Lochscheibe in einer Unteransicht, Figur 3 eine Lochscheibe im Schnitt entlang der Linie III-III in Figur 2, Figur 4 einen Durchströmungsbereich einer dreischichtigen Lochscheibe, Figur 5 einen Durchströmungsbereich einer dreischichtigen Lochscheibe mit einem ersten Kanalfortsatz, Figur 6 einen Durchströmungsbereich einer dreischichtigen Lochscheibe mit einem zweiten Kanalfortsatz, Figur 7 einen Durchströmungsbereich einer fünfschichtigen Lochscheibe mit Kanalfortsätzen, Figur 8 einen Durchströmungsbereich einer vierschichtigen Lochscheibe mit Kanalfortsätzen, Figur 9 eine schematische Draufsicht auf eine Lochscheibe mit seitlichen Kanalfortsätzen, Figur 10 einen Durchströmungsbereich einer Lochscheibe mit Stolperfalle, Figur 11 eine Lochscheibe in einer Unteransicht, Figur 12 eine Lochscheibe im Schnitt entlang der Linie XII-XII in Figur 11, Figur 13 eine Lochscheibe in einer Unteransicht, Figur 14 eine weitere Lochscheibe in einer Draufsicht mit nichteckigen Öffnungen, Figur 15 eine Lochscheibe im Schnitt entlang der Linie XV-XV in Figur 14 mit schematischen Werkzeugen (in umgekehrter Strömungsrichtung), Figuren 16 bis 20 Verfahrensschritte zur Herstellung einer Lochscheibe mittels Multilayergalvanik, Figur 21 eine Lochscheibe nach dem lateralen Überwachsen, Figur 22 eine Schnittdarstellung einer Lochscheibe mit unterschiedlichen Durchmessern der einzelnen Schichten, Figur 23 eine Draufsicht auf den zentralen Bereich der im Schnitt in der Figur 22 dargestellten Lochscheibe, Figur 24 eine weitere Lochscheibe in einer Draufsicht, Figuren 25 bis 27 drei zentrale Bereiche von Lochscheiben mit jeweils einer rechteckförmigen Einlaßöffnung, Figur 28 eine Lochscheibe in einer Draufsicht mit asymmetrischer Aufteilung der Öffnungsbereiche, Figuren 29 und 30 zwei zentrale Bereiche von Lochscheiben mit asymmetrischer Aufteilung der Öffnungsbereiche, Figur 31 einen zentraler. Bereich einer Lochscheibe mit durchweg kreisförmigen Öffnungen, Figur 32 einen zentralen Bereich einer Lochscheibe mit sechzehn sichelförmigen Einlaßöffnungen und Figur 33 einen zentralen Bereich einer Lochscheibe mit einer annähernd halbkreisförmigen Einlaßöffnung und sichelförmigen Auslaßöffnungen.

### Beschreibung der Ausführungsbeispiele

In der Figur 1 ist als ein Ausführungsbeispiel ein Ventil in der Form eines Einspritzventils für Brennstoffeinspritzanlagen von gemischverdichtenden fremdgezündeten Brennkraftmaschinen teilweise dargestellt. Das Einspritzventil hat einen rohrförmigen Ventilsitzträger 1, in dem konzentrisch zu einer Ventillängsachse 2 eine Längsöffnung 3 ausgebildet ist. In der Längsöffnung 3 ist eine z. B. rohrförmige Ventilnadel 5 angeordnet, die an ihrem stromabwärtigen Ende 6 mit einem z. B. kugelförmigen Ventilschließkörper 7, an dessen Umfang beispielsweise fünf Abflachungen 8 vorgesehen sind, verbunden ist.

Die Betätigung des Einspritzventils erfolgt in bekannter Weise, beispielsweise elektromagnetisch. Zur axialen Bewegung der Ventilnadel 5 und damit zum Öffnen entgegen der Federkraft einer nicht dargestellten Rückstellfeder bzw. Schließen des Einspritzventils dient ein angedeuteter elektromagnetischer Kreis mit einer Magnetspule 10, einem Anker 11 und einem Kern 12. Der Anker 11 ist mit dem dem Ventilschließkörper 7 abgewandten Ende der Ventilnadel 5 durch z. B. eine Schweißnaht mittels eines Lasers verbunden und auf den Kern 12 ausgerichtet.

Zur Führung des Ventilschließkörpers 7 während der Axialbewegung dient eine Führungsöffnung 15 eines Ventilsitzkörpers 16. In das stromabwärts liegende, dem Kern 12 abgewandte Ende des Ventilsitzträgers 1 ist in der konzentrisch zur Ventillängsachse 2 verlaufenden Längsöffnung 3 der zylinderförmige Ventilsitzkörper 16 durch Schweißen dicht montiert. An seiner dem Ventilschließkörper 7 abgewandten, unteren Stirnseite 17 ist der Ventilsitzkörper 16 mit einer z.B. topfförmig ausgebildeten Stützscheibe 21 konzentrisch und fest verbunden, die also unmittelbar an dem Ventilsitzkorper 16 anliegt. Die Stützscheibe 21 weist dabei eine ähnliche Form auf wie bereits bekannte topfförmige Spritzlochscheiben, wobei ein mittlerer Bereich der Stützscheibe 21 mit einer gestuften Durchgangsöffnung 22 versehen ist, um in ihr eine erfindungsgemäße Lochscheibe 23 aufzunehmen.

Die Verbindung von Ventilsitzkörper 16 und Stützscheibe 21 erfolgt beispielsweise durch eine umlaufende und dichte, mittels eines Lasers ausgebildete erste Schweißnaht 25. Durch diese Art der Montage ist die Gefahr einer unerwünschten Verformung der Stützscheibe 21 in ihrem mittleren Bereich mit der Durchgangsöffnung 22 und der darin eingebauten Lochscheibe 23 vermieden. Die Stützscheibe 21 ist des weiteren mit der Wandung der Längsöffnung 3 im Ventilsitzträger 1 beispielsweise durch eine umlaufende und dichte zweite Schweißnaht 30 verbunden.

Die Einschubtiefe des aus Ventilsitzkörper 16 und topfförmiger Stützscheibe 21 bestehenden Ventilsitzteils in die Längsöffnung 3 bestimmt die Größe des Hubs der Ventilnadel 5, da die eine Endstellung der Ventilnadel 5 bei nicht erregter Magnetspule 10 durch die Anlage des Ventilschließkörpers 7 an einer Ventilsitzfläche 29 des Ventilsitzkörpers 16 festgelegt ist. Die andere Endstellung der Ventilnadel 5 wird bei erregter Magnetspule 10 beispielsweise durch die Anlage des Ankers 11 an dem Kern 12 festgelegt. Der Weg zwischen diesen beiden Endstellungen der Ventilnadel 5 stellt somit den Hub dar.

Der kugelförmige Ventilschließkörper 7 wirkt mit der sich in Strömungsrichtung kegelstumpfförmig verjüngenden Ventilsitzfläche 29 des Ventilsitzkörpers 16 zusammen, die in axialer Richtung zwischen der Führungsöffnung 15 und der unteren Stirnseite 17 des Ventilsitzkörpers 16 ausgebildet ist.

Die in der Durchgangsöffnung 22 der Stützscheibe 21 angeordnete und durch die Stützscheibe 21 unmittelbar an der Stirnseite 17 des Ventilsitzkörpers 16 festgehaltene Lochscheibe 23 ist in der Figur 1 nur vereinfacht und beispielhaft dargestellt und wird anhand der nachfolgenden Figuren näher beschrieben. Das Einsetzen der Lochscheibe 23 in eine Stützscheibe 21 und eine Klemmung 31 als Befestigung ist eine mögliche Variante des Anbringens der Lochscheibe 23 stromabwärts der Ventilsitzfläche 29. Eine solche Einspannung als indirekte Befestigung der Lochscheibe 23 am Ventilsitzkörper 16 hat den Vorteil, daß temperaturbedingte Verformungen vermieden werden, die eventuell bei Verfahren wie Schweißen oder Löten auftreten könnten. Die Stützscheibe 21 stellt jedoch keineswegs eine ausschließliche Bedingung zur Befestigung der Lochscheibe 23 dar. Da die Befestigungsmöglichkeiten nicht erfindungswesentlich sind, soll hier nur der Verweis auf übliche bekannte Fügeverfahren, wie Schweißen, Löten oder Kleben, erfolgen.

Die Figur 2 zeigt die Lochscheibe 23 in einer Unteransicht. Die Lochscheibe 23 ist als ebene, flache, kreisförmige und mehrschichtige Scheibe ausgeführt, weshalb sie z. B. auch als Multilayer-Spritzlochscheibe bezeichnet werden kann. In der Stützscheibe 21 liegt die Lochscheibe 23 beispielsweise zentriert vor. Durch die erfindungsgemäßen Verfahren zur Herstellung der Lochscheibe 23 ergibt sich eine Struktur, die aus mehreren Lagen zusammengesetzt ist. Deutlich wird diese Mehrschichtigkeit der Lochscheibe 23 in der Figur 3, die eine Ansicht entsprechend einem Schnitt entlang der Linie III-III in Figur 2 darstellt. In Kurzform seien hier bereits einige wesentliche, unter anderem auch die Verfahren betreffende Merkmale genannt, wobei auf die erfindungsgemäßen Verfahren später detailliert eingegangen wird.

Die in den Figuren 2 und 3 dargestellte Lochscheibe 23 wird in drei metallischen Schichten durch galvanische Abscheidung aufgebaut. Aufgrund der tiefenlithographischen, galvanotechnischen Herstellung gibt es die besonderen Merkmale in der Konturgebung:
- Schichten mit konstanter, über die Scheibenfläche nicht zu variierender Dicke,
- durch die tiefenlithographische Strukturierung weitgehend senkrechte Einschnitte in den Schichten, welche die jeweils durchströmten Hohlräume bilden,
- gewünschte Hinterschneidungen und Überdeckungen der Einschnitte durch mehrschichtigen Aufbau einzeln strukturierter Metallschichten,
- Einschnitte mit beliebigen, achsenparallele Wandungen aufweisenden Querschnittsformen, wie z. B. Rechteck, Vieleck, abgerundetes Rechteck, abgerundetes Vieleck, Ellipse, Kreis usw.
Die einzelnen Schichten werden nacheinander galvanisch abgeschieden, so daß sich die Folgeschicht aufgrund galvanischer Haftung fest mit der darunterliegenden Schicht verbindet.

Bei dem ersten Ausführungsbeispiel bilden also drei kreisförmige Schichten z.B. mit gleichem Außendurchmesser die Lochscheibe 23. Eine obere Schicht 35 weist beispielsweise vier rechteckförmige, jeweils in gleichem Abstand zur Ventillängsachse 2 bzw. zur Mittelachse der Lochscheibe 23 ausgebildete und untereinander um 90° versetzte Einlaßöffnungen 36 auf. Die Einlaßöffnungen 36 sind verglichen mit dem Durchmesser der Lochscheibe 23 sehr nahe der Ventillängsachse 2 angeordnet. Mit einem wesentlich größeren Abstand zur Ventillängsachse 2 und damit einem radialen Versatz zu den Einlaßöffnungen 36 sind in einer unteren Schicht 37 ebenfalls vier rechteckförmige Auslaßöffnungen 38 vorgesehen. Die Auslaßöffnungen 38 weisen beispielsweise eine geringfügig kleinere Öffnungsweite als die Einlaßöffnungen 36 auf. Zwei senkrecht zueinander verlaufende, sich an der Ventillängsachse 2 schneidende Achsen 39 der Lochscheibe 23 teilen die Einlaßöffnungen 36 sowie die Auslaßöffnungen 38 jeweils mittig auf, so daß beide Achsen 39 Symmetrieachsen der symmetrisch aufgebauten Lochscheibe 23 darstellen. Entlang der Achsen 39 erstrecken sich ebenfalls in einer mittleren, zwischen der oberen und unteren Schicht 35 und 37 liegenden Schicht 40 radiale Kanäle 42, die eine direkte Verbindung von Einlaßöffnungen 36 und Auslaßöffnungen 38 bilden. Die leicht trapezförmigen Kanäle 42 besitzen z. B. eine solche Größe, daß sie in der Projektion die Einlaßöffnungen 36 und die Auslaßöffnungen 38 gerade überdecken. Alle vier Kanäle 42 liegen bei diesem Ausführungsbeispiel separat voneinander vor. In den Figuren 2 und 3 sind durch Strichlinien weitere mögliche Varianten angedeutet, bei denen die Kanäle 42 verschiedene, deutlich größere radiale Abmessungen besitzen, so daß dann die Kanäle 42 über die Auslaßöffnungen 38 der unteren Schicht 37 radial nach außen deutlich herauslaufen (siehe Figuren 5 und 6).

Bei einem Durchmesser von 4 bis 5 mm besitzt die Lochscheibe 23 z. B. eine Dicke von 0,5 mm, wobei die obere und die untere Schicht 35 und 37 beispielsweise jeweils 0,1 mm und die mittlere Schicht 40 0,3 mm stark sind. Diese Größenangaben zu den Abmessungen der Lochscheibe 23 sowie alle weiteren in der Beschreibung angegebenen Maße dienen nur dem besseren Verständnis und schränken die Erfindung in keiner Weise ein. Auch die relativen Abmaße der einzelnen Strukturen der Lochscheibe 23 in sämtlichen Figuren sind nicht unbedingt maßstäblich.

Aufgrund des bereits angesprochenen radialen Versatzes der Auslaßöffnungen 38 gegenüber den Einlaßöffnungen 36 ergibt sich ein S-förmiger Strömungsverlauf des Mediums, beispielsweise des Brennstoffs. Anhand der Figur 4, die nochmals einen Durchströmungsbereich der Lochscheibe 23 im axialen Schnitt mit der Einlaßöffnung 36, dem Kanal 42 und der Auslaßöffnung 38 hervorhebt, sollen die prinzipiellen Strömungsverhältnisse erläutert werden. Die den Strömungsverlauf kennzeichnenden Pfeile zeigen deutlich die S-Form, weshalb auch bei den erfindungsgemäßen Lochscheiben 23 von S-Typ-Scheiben die Rede ist. Die Lochscheibe 23 wird also von der Einlaßöffnung 36 bis zu der jeweils zugeordneten Auslaßöffnung 38 durchströmt. Von der Einlaßöffnung 36 ausgehend wird die Strömung pro Einlaßöffnung 36 durch den jeweiligen horizontal verlaufenden Kanal 42 radial nach außen geführt. Am Kanalende befindet sich dann bei dem Beispiel nach Figur 4 die Auslaßöffnung 38.

Durch den radial verlaufenden Kanal 42 erhält das Medium eine Radialgeschwindigkeitskomponente. Die Strömung verliert im kurzen axialen Auslaßdurchtritt ihre Radialgeschwindigkeitskomponente nicht völlig. Vielmehr tritt sie mit einseitiger Ablösung an der der Einlaßöffnung 36 zugewandten Wandung der Auslaßöffnung 38 unter einem Winkel zur Ventillängsachse bzw. Mittelachse 2 aus der Lochscheibe 23 aus. Die Kombination mehrerer, z. B. asymmetrisch zueinander ausrichtbarer Einzelstrahlen, die sich durch eine entsprechende Anordnung und Ausrichtung mehrerer Einheiten aus Ein-, Auslaßöffnungen 36 und 38 und Kanälen 42 erzielen lassen, ermöglicht völlig neue, individuelle, komplexe Gesamtstrahlformen mit unterschiedlichen Mengenverteilungen.

Durch den sogenannten S-Schlag innerhalb der Lochscheibe 23 mit mehreren starken Strömungsumlenkungen wird der Strömung eine starke, zerstäubungsfördernde Turbulenz aufgeprägt. Der Geschwindigkeitsgradient quer zur Strömung ist dadurch besonders stark ausgeprägt. Er ist ein Ausdruck für die Änderung der Geschwindigkeit quer zur Strömung, wobei die Geschwindigkeit in der Mitte der Strömung deutlich größer ist als in der Nähe der Wandungen. Die aus den Geschwindigkeitsunterschieden resultierenden erhöhten Scherspannungen im Fluid begünstigen den Zerfall in feine Tröpfchen nahe der Auslaßöffnungen 38. Da die Strömung im Auslaß einseitig abgelöst ist, erfährt sie wegen fehlender Konturführung keine Strömungsberuhigung. Eine besonders hohe Geschwindigkeit weist das Fluid an der abgelösten Seite auf, während die Geschwindigkeit des Fluids zur Seite der Auslaßöffnung 38 mit anliegender Strömung abfällt. Die zerstäubungsfördernden Turbulenzen und Scherspannungen werden somit im Austritt nicht vernichtet.

In den Figuren 5 und 6 sind Ausführungsbeispiele von Lochscheiben 23 dargestellt, bei denen die Kanäle 42 in der mittleren Schicht 40 nicht nur von den Einlaßöffnungen 36 bis hin zu den Auslaßöffnungen 38 verlaufen, sondern über die Auslaßöffnungen 38 hinaus in Richtung der äußeren Begrenzung der Lochscheiben 23. Diese Verlängerungen der Kanäle 42 werden nachfolgend als Kanalfortsätze 43 (cavities) bezeichnet. Zum Prinzip der Strömungsführung und zur Auswirkung auf die Strahlformgebung und Zerstäubung gelten prinzipiell die bereits gemachten Aussagen. Die in die Auslaßöffnung 38 strömende Flüssigkeit streicht weitgehend an dem Kanalfortsatz 43 (cavity) vorbei und treibt in dem Kanalfortsatz 43 einen Strömungswirbel an. Die Wechselwirkung zwischen dem Wirbel und der antreibenden Strömung führt zu zeitlichen Instabilitäten im Wechselwirkungsgebiet. Periodisch verändert der Wirbel seine Größe und drängt beim Anwachsen die vorbeistreichende Strömung ab (entsprechend umgekehrt beim Kleinerwerden des Wirbels). Die austretende Strömung wird somit periodisch in der Richtungsgebung abgelenkt und damit zu Schwingungen angeregt. Frequenz und Amplitude der Oszillationen in der Austrittsströmung hängen dabei von der Gestaltung des Kanalfortsatzes 43 ab, und zwar von der radialen Tiefe c und der Höhe h, die sich durch die Dicke der mittleren Schicht 40 ergibt. In dem in der Figur 5 gezeigten Ausführungsbeispiel gilt z. B. c = h, während bei dem Beispiel in Figur 6 für die Größe des Kanalfortsatzes 43 c = 2 x h gilt. Die Geometrie des in der Figur 6 gezeigten Kanalfortsatzes 43 führt dazu, daß ein Doppelwirbel entsteht, wobei sich beide Wirbel durch Impulsaustausch antreiben und eine gegensinnige Wirbelrichtung aufweisen.

Durch die Oszillationen in den einzelnen Austrittsstrahlen ergeben sich sowohl in den Einzelstrahlen als auch im Gesamtspray Schwingungsmuster. Durch diese Schwingungsmuster sind die unterschiedlichsten bizarren Strahlquerschnitte erreichbar (z. B. Rechteck, Dreieck, Kreuz, Kreis). Ohne solche Strahlschwingungen wären diese Querschnittsformen nicht erzielbar; sonst besteht die Tendenz zu kreisförmigen Querschnitten der Einzelstrahlen. Die beliebigen Muster bzw. Querschnitte der Einzelstrahlen bzw. des Gesamtsprays als Summe aller Einzelstrahlen, die sich durch Impulsaustausch in ständiger Wechselwirkung miteinander befinden, sind also besonders dann erreichbar, wenn die Oszillationen im Fluid hochfrequent sind. Zudem wird durch die Richtungsänderungen das Spray gleichmäßiger über den Strahlquerschnitt verteilt. Dadurch wird das Spray homogener und durchmischt sich so besser mit der Saugrohrluftströmung zur Bildung eines abgasreduzierenden Gemisches.

Die durch die Turbulenz vorhandenen Querimpulse quer zur Strömung führen unter anderem dazu, daß die Tröpfchenverteilungsdichte im abgespritzten Spray eine große Gleichmäßigkeit aufweist. Daraus resultiert eine herabgesetzte Wahrscheinlichkeit von Tröpfchenkoagulationen, also von Vereinigungen kleiner Tröpfchen zu größeren Tropfen. Die Folge der vorteilhaften Reduzierung des mittleren Tröpfchendurchmessers im Spray ist eine relativ homogene Sprayverteilung. Durch den S-Schlag wird in dem Fluid eine feinskalige (hochfrequente) Turbulenz erzeugt, welche den Strahl unmittelbar nach Austritt aus der Lochscheibe 23 in entsprechend feine Tröpfchen zerfallen läßt. Je größer die sich aus der Turbulenz ergebenden Scherspannungen sind, desto größer ist auch die Streuung der Strömungsvektoren. Die Scherspannungen sorgen dafür, daß ein "chaotischer Zustand" in allen Ebenen des Fluids herrscht, so daß eine gewünschte Spreizung der Strahlen bzw. des Sprays auftritt, die zu den bereits angesprochenen unterschiedlichen Querschnitten bzw. Mustern führen kann.

In den Figuren 7, 8 und 9 sind einige leicht abgewandelte Ausführungsbeispiele dargestellt, die sich vor allen Dingen von den vorhergehenden Ausführungsbeispielen dadurch unterscheiden, daß sie mehr als drei Schichten aufweisen und Kanalfortsätze 43' nicht nur in radialer Richtung als Verlängerung des Kanals 42 besitzen. In der Figur 7 ist eine fünfschichtige Lochscheibe 23 gezeigt, in der neben den bekannten drei Schichten 35, 37 und 40 noch zwei weitere mittlere Schichten 40' ausgebildet sind. Diese zwei zusätzlichen Schichten 40' liegen jeweils zwischen der mittleren Schicht 40 und der oberen bzw. unteren Schicht 35 bzw. 37. Um ein Durchströmen des Fluids durch die Lochscheibe 23 von der Einlaßöffnung 36 bis zur Auslaßöffnung 38 zu gewährleisten, besitzen die beiden Schichten 40' auch entsprechende Öffnungsbereiche 45, die die Verbindung zum in der Schicht 40 vorgesehenen Kanal 42 herstellen. Neben diesen Öffnungsbereichen 45 ist in den Schichten 40' noch jeweils wenigstens ein Kanalfortsatz 43' eingebracht, der z. B. die axiale Höhe der Schicht 40' hat. In radialer Richtung gesehen liegen die Kanalfortsätze 43' beispielsweise zwischen der Einlaßöffnung 36 und der Auslaßöffnung 38. Die Strömung des Fluids treibt nun wieder Strömungswirbel in den Kanalfortsätzen 43' an. Zusätzlich zu den axial versetzt zum Kanal 42 liegenden Kanalfortsätzen 43' können auch radial an den Kanal 42 anschließende Kanalfortsätze 43 vorgesehen sein.

Die Figur 8 zeigt eine Variante einer Lochscheibe 23 mit vier Schichten, also nur mit einer zusätzlichen mittleren Schicht 40'. Je nach Anordnung der Schicht 40' oberhalb oder unterhalb der Schicht 40 muß die Schicht 40' wiederum einen Öffnungsbereich 45 aufweisen, hier in der Figur 8 einen unmittelbar an der Auslaßöffnung 38 eingebrachten Öffnungsbereich 45. In der Schicht 40' befinden sich zusätzlich Kanalfortsätze 43', die axial zum Kanal 42 versetzte Kammern darstellen, in denen Strömungswirbel entstehen. Die z. B. drei Kanalfortsätze 43' in der Schicht 40' können im gleichen Abstand zueinander oder auch willkürlich aufgeteilt sein. Eine schematische Draufsicht auf einen Teil einer Lochscheibe 23 zeigt die Figur 9. Dabei wird deutlich, daß die Kanalfortsätze 43' nicht nur in axialer Richtung der Lochscheibe 23, also in die Tiefe, eingebracht sein können, sondern durchaus über die Breite des Kanals 42 hinausragend ausgebildet sein können. Somit sind Kanalfortsätze 43, 43' in allen drei Richtungen, also in Länge, Breite und Tiefe, am Kanal 42 ausformbar.

Alle vorangegangenen Beispiele können mit dem Merkmal einer Grenzschichtstolperfalle, wie sie die Figur 10 zeigt, ausgestattet werden. Die Lochscheibe 23 ist in diesem konkreten Fall vierschichtig ausgebildet. Zwischen den beiden oberen und unteren Schichten 35 und 37 befinden sich nun z. B. zwei mittlere Schichten 40 und 40'. Die zusätzliche mittlere Schicht 40', die unmittelbar auf der unteren Schicht 37 folgt, ist derart ausgebildet, daß sich quer zur Strömungsrichtung im Bereich des Kanals 42 eine z. B. quaderförmige, scharfkantige Erhebung, nämlich eine Stolperfalle 50 erstreckt. Denkbar ist natürlich auch die Anordnung einer Stolperfalle 50 in der mittleren Schicht 40, so daß dann die Stolperfalle 50 von oben in den Kanal 42 hineinragen würde. Von der Geometrie her sollte die Stolperfalle 50 mit radialem Versatz zur Einlaßöffnung 36 ausgeformt sein. Der Kanal 42 erstreckt sich zwischen den Schichten 35 und 37 sowohl in der Schicht 40 als auch in der Schicht 40'.

Die Hauptströmung des Fluids streicht über die Grenzschichtstolperfalle 50. An einer hinteren, stromabwärtigen Stolperkante 51 löst sich die Strömung von der Stolperfalle 50 ab und erfährt wegen der plötzlichen Querschnittserweiterung stromab der Stolperfalle 50 einen Druckanstieg (Umwandlung von kinetischer Energie in Druckenergie - Diffusorwirkung). Dieser Druckanstieg führt zu intensiven Grenzschichtverwirbelungen im Nachlauf der Stolperfalle 50.

Es entsteht im Nachlauf der Stolperfalle 50 eine stets größerwerdende Wirbelschleppe mit starken Querimpulsen, welche bis zur Auslaßöffnung 38 reicht. Die Wirbelschleppe zieht sich durch die Hauptströmung als "Turbulenzstrang" durch. Die Turbulenz in der Wirbelschleppe kann sehr feinskalig (hochfrequent) sein und eine große Amplitude aufweisen. Die Frequenz- und Amplitudenabstimmung erfolgt über die Höhe der Stolperfalle 50 und die Geschwindigkeit der vorbeistreichenden Hauptströmung, d. h. über die Kanalquerschnittsfläche oberhalb der Stolperfalle 50.

Die Wirbelschleppe kann Durchströmverluste reduzieren, da in ihr ein hoher turbulenter Impulsaustausch quer zur Hauptströmung in Richtung der Wandungen stattfindet. Daraus ergibt sich, daß die Hauptströmung im Nachlauf der Stolperfalle 50 weniger zum Ablösen von den Wandungen des Kanals 42 neigt und dadurch die zur Verfügung stehenden Durchströmquerschnitte besser nutzt. Eine Ablösung der Strömung von der Wandung würde zu einem Druckverlust führen. Auch die Stolperfalle 50 dient dazu, ein homogenes Spray abzuspritzen, das in sehr feine Tröpfchen zerfällt, wobei wiederum die unterschiedlichsten Abspritzmuster erzielbar sind.

In den vorangegangenen Beispielen besaß ein jedes Einlaß-/Auslaßöffnungspaar 36, 38 einen separaten Kanal 42 als Verbindung dieser Öffnungen 36, 38. Im Gegensatz dazu ist in den Figuren 11 und 12 ein Ausführungsbeispiel dargestellt, das nur einen einzigen zusammenhängenden Kanal 42' in der Lochscheibe 23 aufweist. Alle vier Einlaßöffnungen 36 münden in diesen z. B. quadratförmigen Kanal 42', und alle vier Auslaßöffnungen 38 führen auch wieder aus dem Kanal 42' heraus. Bei Verwendung rechteckiger oder quadratischer Auslaßöffnungen 38 bietet es sich an, die Außenkontur des Kanals 42' in der mittleren Schicht achteckig, durch die Nähe jeweils zweier Ecken jedoch fast quadratisch auszubilden, so wie es die Figur 11 zeigt. Nach innen ist der Kanal 42' durch eine z. B. quadratische Materialinsel 53 der mittleren Schicht 40 begrenzt. Diese innere Materialinsel 53 hat ungefähr eine solche Größe im Querschnitt, wie der sich zwischen den Einlaßöffnungen 36 ergebende Bereich in der oberen Schicht 35. Die Schicht 40 besteht also aus zwei Abschnitten, nämlich aus der von dem Kanal 42' vollständig umgebenen Materialinsel 53 und einem wiederum den Kanal 42' vollständig umgebenden Außenbereich 54. Die Figur 12 ist eine Ansicht der Lochscheibe 23 entsprechend einem Schnitt entlang der Linie XII-XII in Figur 11.

Durch das zusätzlich entstandene Verbindungsvclumen gibt es zunehmend sogenannte Totwassergebiete, an denen die Hauptströmung vorbeistreicht. In den Totwassergebieten entsteht die Schwingungsanregung der Hauptströmung nach dem Cavityprinzip mit den Kanalfortsätzen 43, 43'. Entsprechend ist die Auswirkung auf die Strahlformgebung und die Zerstäubung identisch wie bei den vorangegangenen Beispielen mit den Kanalfortsätzen 43, 43' (Cavities).

Der Versatz der Auslaßöffnungen 38 zu den Einlaßöffnungen 36 muß keineswegs radial verlaufen, wie es in den vorhergehenden Beispielen der Fall war, sondern kann in beliebige gewünschte Richtungen vorgesehen sein. Zwei Ausführungsbeispiele für einen solchen anderen Versatz zeigen die Figuren 13 und 14 als Unteransicht bzw. Draufsicht auf jeweils eine Lochscheibe 23. Hierbei wird deutlich, daß die Auslaßöffnungen 38 eher in Umfangsrichtung zu den Einlaßöffnungen 36 versetzt sind, also z. E. um 90° gedreht gegenüber den Beispielen mit radialem Versatz. Der Kanal 42' in der mittleren Schicht 40 der Lochscheibe 23 in Figur 13 besitzt z. B. eine achteckige, jedoch weitgehend quadratische Außenkontur, wobei die Ecken der Wandung des Kanals 42' immer nahe der Einlaß- und Auslaßöffnungen 36 und 38 liegen. Die Materialinsel 53 der mittleren Schicht 40 begrenzt den Kanal 42' nach innen mit einer ebenfalls fast quadratischen, allerdings acht Ecken aufweisenden Kontur. Die äußere und die innere Begrenzungswand des Kanals 42' sind beispielsweise um 45° zueinander verdreht ausgebildet. Damit weisen der Außenbereich 54 und die Materialinsel 53 keine parallel verlaufenden Wandungen auf.

Die in den Figuren 14 und 15 (Schnitt entlang der Linie XV-XV in Figur 14) gezeigte Lochscheibe 23 zeichnet sich besonders durch ihre nichteckigen Einlaß- und Auslaßöffnungen 36 und 38 aus. Die Einlaßöffnungen 36 in der oberen Schicht 35 besitzen z.B. einen elliptischen Querschnitt, während die Auslaßöffnungen 38 in der unteren Scheibe 37 kreisförmig ausgebildet sind. Die innere Materialinsel 53 weist beispielsweise einen quadratischen Querschnitt auf, während der Kanal 42' in der mittleren Schicht 40 nach außen hin vom Außenbereich 54 kreisförmig begrenzt wird. Zum besseren Handling der Lochscheiben 23 bei der Anwendung der verschiedenen Herstellungsverfahren sind z.B. zwei Positionieraufnahmen 56 in Form von Durchgangslöchern nahe der äußeren Begrenzung vorgesehen.

Die Einlaßöffnungen 36 und die Auslaßöffnungen 38 können mit beliebig großem Versatz zueinander angeordnet sein. Bei den Ausführungsbeispielen in den Figuren 13 und 14 liegen beispielsweise wesentlich geringere Versätze vor als bei allen anderen zuvor gezeigten Beispielen. Über die Größe des Versatzes können die Strahlrichtung und der Turbulenzgrad abgestimmt bzw. eingestellt werden.

Die bis Figur 13 gezeigten Einlaßöffnungen 36, Auslaßöffnungen 38 sowie Kanäle 42, 42' besitzen stets quadratische bzw. rechteckförmige Querschnitte. Die erfindungsgemäßen Verfahren erlauben es jedoch, auch völlig andere Querschnitte der durchströmten Geometrien der Lochscheibe 23 zu erzeugen (siehe Figur 14). Denkbar sind Abwandlungen zu Querschnitten bestehend aus abgerundeten Rechtecken oder Quadraten, Kreisen, Kreissegmenten, Ellipsen, Ellipsensegmenten, Vielecken, abgerundeten Vielecken usw. Die Wandungen der einzelnen Strukturen verlaufen dabei weitgehend parallel zur Ventillängsachse 2. Interessant kann auch die unterschiedliche Ausbildung von Einlaßöffnungen 36 und Auslaßöffnungen 38 sein, die über einen Kanal 42, 42' direkt miteinander verbunden sind. Geeignete Querschnittsveränderungen stellen z. B. die Übergänge von Quadrat zu Rechteck und umgekehrt, von Rechteck zu Kreis und umgekehrt, von Ellipse zu Kreis und umgekehrt dar.

Anhand der Figuren 16 bis 21 wird ein erfindungsgemäßes, zur Herstellung der Lochscheibe 23 besonders geeignetes und bevorzugtes Herstellungsverfahren näher verdeutlicht. Dabei zeigen die Figuren nicht genau die in den Figuren 1 bis 15 dargestellten Ausführungsbeispiele von Lochscheiben 23 mit den entsprechenden gewünschten Konturen, sondern nur das Herstellungsprinzip verdeutlichende Anordnungen. Gerade die relativen Abmaße der Schichtdicken im Vergleich zu den Größen der Öffnungen bzw. Kanäle weichen besonders bei den in den Figuren 16 bis 20 gezeigten Beispielen von den zuvor beschriebenen Ausführungsbeispielen ab. Die erfindungsgemäßen Herstellungsverfahrensschritte lassen jedoch eine Herstellung aller gezeigten Ausführungsbeispiele jederzeit zu.

Aufgrund der hohen Anforderungen an die Strukturdimensionen und die Präzision von Einspritzdüsen gewinnen Mikrostrukturierungsverfahren heute eine zunehmende Bedeutung für ihre großtechnische Herstellung. Im allgemeinen wird für den Fluß des Fluids, z. B. des Brennstoffs, innerhalb der Düse bzw. der Lochscheibe ein Verlaufsweg gefordert, der die bereits angesprochene Turbulenzbildung innerhalb der Strömung begünstigt. Zusätzlich sollen die Breiten der Auslaßöffnungen in der Größe von wenigen 10 Mikrometern liegen, um eine möglichst effektive Zerstäubung des Fluids, z. B. des Brennstoffs, zu erreichen. Mit der vorliegenden Erfindung wird ein Verfahren zur Herstellung metallischer Lochscheiben vorgeschlagen, die auf der sukzessiven Anwendung von photolithographischen Schritten (UV-Tiefenlithographie) und anschließender Mikrogalvanik beruht. Charakteristisch für das Verfahren ist, daß es auch in großflächigem Maßstab eine hohe Präzision der Strukturen gewährleistet, so daß es ideal für eine Massenfertigung mit sehr großen Stückzahlen einsetzbar ist. Auf einem Wafer kann eine Vielzahl von Lochscheiben 23 gleichzeitig mittels der erfindungsgemäßen Verfahrensschritte gefertigt werden.

Ausgangspunkt für das Verfahren ist eine ebene und stabile Trägerplatte 60, die z. B. aus Metall (Kupfer), Silizium, Glas oder Keramik bestehen kann. Die üblichen Dicken dieser Trägerplatte 60 liegen zwischen 500 µm und 2 mm; sie haben allerdings keinen Einfluß auf die folgenden Verfahrensschritte. Nach der Reinigung der Trägerplatte 60 wird bei Verwendung eines elektrisch nicht leitenden Materials, wie Glas oder Silizium, zunächst wenigstens eine Hilfsschicht 61 auf die Trägerplatte 60 aufgalvanisiert. Dabei handelt es sich beispielsweise um eine Galvanikstartschicht 61' (z.B. Cu), die zur elektrischen Leitung für die spätere Mikrogalvanik benötigt wird. Die Galvanikstartschicht 61' kann auch als Opferschicht 61 dienen, um später ein einfaches Vereinzeln der Lochscheibenstrukturen durch Ätzung zu ermöglichen. Besteht die Trägerplatte 60 bereits aus einem leitfähigen Material, wie z.B. Kupfer, so kann auf die Galvanikstartschicht 61' verzichtet werden. Falls Kupfer als Opfer-/Galvanikstartschicht 61, 61' verwendet wird, muß eine dünne (z.B. 80 nm) Chromschicht als Haftschicht 61'' zwischen der Trägerplatte 60 und der Galvanikstartschicht 61' aufgebracht werden. Das Aufbringen der Hilfsschicht 61, 61', 61'' (typischerweise also CrCu oder CrCuCr bei Verwendung eines Polyimids als Photoresist) geschieht z.B. durch Sputtern oder durch stromlose Metallabscheidung.

Nach dieser Vorbehandlung der Trägerplatte 60 wird auf die optionale Hilfsschicht 61, 61', 61'' ein Photoresist (Photolack) 63 ganzflächig aufgebracht. Dafür bieten sich besonders drei verschiedene Varianten an:
1. Laminieren eines Festresists bei z. B. rund 100°C,
2. Aufschleudern eines Flüssigresists oder
3. Aufschleudern eines Polyimids in flüssigem Zustand.

Nach dem Trocknen liegt der Photoresist 63 bei allen drei Varianten in fester Form vor. Die Dicke des Photoresists 63 sollte dabei der Dicke der Metallschicht entsprechen, die in dem später folgenden Galvanikprozeß realisiert werden soll, also der Dicke der unteren Schicht 37 der Lochscheibe 23. Typischerweise werden Schichtdicken zwischen 10 und 300 µm angestrebt je nach gewünschter Dicke der Schichten der Lochscheibe 23. Die zu realisierende Metallstruktur soll mit Hilfe einer photolithographischen Maske 64 invers in dem Photoresist 63 übertragen werden. Es gibt zum einen die Möglichkeit, den Photoresist 63 direkt über die Maske 64 mittels UV-Belichtung 65 zu belichten (UV-Tiefenlithographie). Eine andere Möglichkeit der Strukturierung des Photoresists 63 sieht vor, daß auf dem Photoresist 63 ein Oxid (z. B. SiO₂) oder ein Nitrid abgeschieden wird, welches photolithographisch strukturiert als Maske für einen Trockenätzprozeß des Photoresists 63 dient. Außerdem bietet sich eine Laserablation an, wobei nach dem Aufbringen einer Maske explosionsartig Material des Photoresists 63 mit Hilfe eines Lasers abgetragen wird.

Diese vorgenannten Verfahrensschritte sind bildlich in der Figur 16 zusammengefaßt.

Nach der Entwicklung des UV-belichteten Photoresists 63 bzw. der Anwendung der anderen erwähnten Verfahren (Trockenätzen, Ablatieren) ergibt sich eine durch die Maske 64 vorbestimmte Struktur im Photoresist 63, wie sie die Figur 17 zeigt. Diese Struktur im Photoresist 63 stellt eine Negativstruktur 66 zur späteren Schicht 37 der Lochscheibe 23 dar. Die Figur 18 zeigt die Struktur nach der galvanischen Auffüllung der im Photoresist 63 entstandenen Resistgräben 68 mindestens bis zur Oberkante des Photoresists 63. Bei dem Verfahrensschritt des Galvanisierens wird also in den Resistgräben 68 Metall 70 auf der Trägerplatte 60 abgeschieden. Das Metall 70 legt sich durch das Galvanisieren eng an die Kontur der Negativstruktur 66 an, so daß die vorgegebenen Konturen formtreu in ihm reproduziert werden. Um mehrschichtige Lochscheibenstrukturen herzustellen, sollte die Höhe der Galvanikschicht des Metalls 70 der Höhe des Photoresists 63 entsprechen. Die Photoresiststruktur 63 kann je nach gewünschtem Design auch höher als die gewünschte Galvanikschicht sein. Dadurch kann sogar die Galvanikschichtdickenverteilung verbessert werden. Die Wahl des abzuscheidenden Materials hängt von den jeweiligen Anforderungen an die Schicht ab, wobei besonders die Faktoren mechanische Festigkeit, chemische Beständigkeit, Schweißbarkeit und andere gewichtig sind. Üblicherweise kommen Ni, NiCo, NiFe oder Cu zum Einsatz; es sind aber auch andere Metalle und Legierungen denkbar.

Um die Struktur der Lochscheibe 23 zu realisieren, müssen die Schritte ab dem optionalen Aufbringen der Hilfsschicht 61, 61', 61'' entsprechend der Anzahl der gewünschten Schichten wiederholt werden. Mit der Figur 19 wird dies angedeutet, wobei die Schicht des Photoresists 63' z. B. zur Bildung der spateren mittleren Schicht 40 der Lochscheibe 23 dient. Die Bezugszeichen mit Strich weisen auf einen wiederholten Prozeß hin. Die einzelnen Metallschichten werden aufeinander abgeschieden und durch metallisches Haften aneinander gehalten. Für die Schichten einer Lochscheibe 23 können auch unterschiedliche Metalle 70 verwendet werden.

Abschließend erfolgt das Vereinzeln der Lochscheiben 23. Dazu wird die Opferschicht 61 weggeätzt, wodurch die Lochscheiben 23 von der Trägerplatte 60 abheben. Danach werden die Galvanikstartschichten 61' durch Ätzung entfernt und der verbliebene Photoresist 63, 63' aus den Metallstrukturen herausgelöst. Dies kann z. B. durch eine KOH-Behandlung oder durch ein Sauerstoffplasma bzw. mittels Lösungsmitteln (z. B. Aceton) bei Polyimiden ermöglicht werden. Diese Prozesse des Herauslösens des Photoresists 63, 63' sind allgemein unter dem Oberbegriff "Strippen" bekannt. Als alternative Lösung ist auch ein mechanisches Lösen von der Trägerplatte 60 bei geeigneter Wahl der Galvanikstartschicht 61' z. B. mittels Magneten denkbar. Die Figur 20 zeigt eine dreischichtige, von der Trägerplatte 60 abgelöste Lochscheibe 23 beispielhaft, wobei die Höhe der Einlaßöffnungen 36 und der Auslaßöffnungen 38 üblicherweise kleiner sein wird.

In der Figur 21 ist ein weiteres Ausführungsbeispiel einer Lochscheibe 23 vom "S-Typ" dargestellt, die durch eine sich von der eben beschriebenen Herstellungsweise unterscheidende Technologie hergestellt ist. Diese neue Technologie kann mit dem Begriff "laterales Überwachsen" bezeichnet werden. Das Verfahren des "lateralen Überwachsens" ermöglicht, daß zwei sich berührende, in der bisherigen Ausführung als Schichten bezeichnete und dargestellte Ebenen der Lochscheibe 23 in einem Schritt durch galvanische Abscheidung ausgebildet werden können, ohne daß z.E. bei einer "Drei-Schicht-Lochscheibe" ein drittes Galvanisieren nötig ist. Die beiden so durch das "laterale Überwachsen" gebildeten Ebenen sind also in dem Sinne keine voneinander getrennt aufgebauten Schichten mehr, sondern stellen nur noch eine Schicht im Sinne eines einzelnen Aufwachsens ohne dazwischenliegende Begrenzung dar.

Die Herstellung der unteren Schicht 37 erfolgt zunächst in bekannter Weise, wie aus den Figuren 16 bis 18 ersichtlich ist. Das galvanisch abzuscheidende Metall 70 wächst dann in der bekannten Form um die Photoresiststruktur 63' der zweiten Schicht bis zur Oberkante des Photoresists 63' (Figur 19). Danach wächst jedoch die Galvanik über den Photoresist 63' hinaus. Das Überwachsen der Photoresiststruktur 63' erfolgt in horizontaler und vertikaler Richtung ungefähr in gleicher Größenordnung. Dieses Überwachsen ersetzt das Aufbringen einer weiteren Galvanikstartschicht 61' und die dritte Galvanikschicht an sich, da zwei Schichten 35, 40 der späteren Lochscheibe 23 in einem Galvanikschritt erzeugt werden. Die Höhe des Überwachsens wird so eingestellt, daß die gebildeten Einlaßöffnungen 36 in der oberen wachsenden Schicht 35' den Anforderungen an die S-Typ-Scheiben entsprechen, also einen Versatz zu den Auslaßöffnungen 38 aufweisen. Das Überwachsen wird frühestens dann abgebrochen, wenn die Auslaßöffnungen 38 vollständig vom Material der überwachsenden Schicht 35' überdeckt sind. Bei dieser Verfahrensweise werden also zwei Schichten des Photoresists 63, 63' umwachsen, die die Größe der Auslaßöffnungen 38 und der Kanäle 42 vorgeben. Es bietet sich auch die Möglichkeit an, die Größe der Einlaßöffnungen 36 durch Photoresist 63' als weitere strukturierte Lackschicht zu definieren. Dazu liegt dann die Photoresiststruktur 63, 63' in drei Ebenen vor. Diese dritte Schicht des Photoresists 63' dient letztlich als "Anschlag" für das laterale Überwachsen der Schicht 35' zur definierten Ausbildung der Einlaßöffnungen 36.

Auf diese Weise können runde, ovale oder mehreckige Einlaßöffnungen 36 erzielt werden. Mit Hilfe des "lateralen Überwachsens" wird besonders die Zeit zur Herstellung der Lochscheibe 23 deutlich verkürzt. Außerdem ist die Rauheit der Galvanikoberfläche verringert. Mit der Zahl der aufzubringenden Schichten nimmt nämlich auch die Rauheit der Galvanikoberfläche zu. Zusätzliche Glättungsmaßnahmen, wie z. B. mittels Elektropolieren, sind somit nicht unbedingt nötig. Ein weiterer Vorteil des lateralen Überwachsens besteht darin, daß für die Ausformung der Einlaßöffnungen 36 keine neue Galvanikstartschicht 61' auf dem elektrisch nicht leitenden Photoresist 63' aufgebracht werden muß.

In den Figuren 22 bis 33 sind weitere Ausführungsbeispiele von Lochscheiben 23 dargestellt, die nur in Kurzform erläutert werden sollen, da sie alle grundsätzlichen Merkmale der "S-Typ-Scheibe" aufweisen und nur interessante Designs bzw. Gestaltungsformen aufzeigen. Alle diese nun folgenden Ausführungsbeispiele von Lochscheiben können mit dem soeben näher beschriebenen Herstellverfahren der galvanischen Metallabscheidung aufgebaut werden.

Die Figuren 22 und 23 zeigen eine Lochscheibe 23, die wiederum zumindest teilweise mittels lateralen Überwachsens hergestellt ist. Dabei weist die obere Schicht 35' wenigstens zwei Funktionsebenen auf, d.h. eine Ebene, in der sich der Kanal 42' erstreckt, und eine darüberliegende Ebene, die die Einlaßöffnung 36 aufweist. Die untere Schicht 37 besitzt z.B. einen wesentlich größeren Durchmesser als die obere Schicht 35'. Während die Einlaßöffnung 36 einen kreisförmigen Querschnitt aufweist, sind die vier Auslaßöffnungen 38 in einer Kreisbogenform sichelförmig angeordnet. Der in der unteren Ebene der oberen Schicht 35' befindliche Kanal 42' ist ebenso wie die Einlaßöffnung 36 kreisförmig ausgeführt, und zwar mit einem Durchmesser, der etwas größer als der Außendurchmesser der sichelförmigen Auslaßöffnungen 38 ist. Der sogenannte S-Schlag des Fluids findet bei dieser Anordnung radial nach außen statt. Dadurch erhält man ein radialsymmetrisches Strahlbild mit guter Zerstäubung.

Die Figur 24 zeigt eine Lochscheibe 23 in der Draufsicht, durch die eine Flachstrahlabspritzung möglich ist. Die vier Einlaßöffnungen 36 in der oberen Schicht 35 sind rechteckförmig ausgeführt. Jeder Einlaßöffnung 36 ist genau ein Kanal 42 und eine Auslaßöffnung 38 zugeordnet. Die Auslaßöffnungen 38 sind beispielsweise quadratisch oder rechteckig ausgebildet. Die die Ein- und Auslaßöffnungen 36 und 38 in der Projektion vollständig überdeckenden Kanäle 42 besitzen eine sechseckige Kontur, die entsprechend der Größe der Ein- und Auslaßöffnungen 36 und 38 verändert werden kann. Die Versätze der Ein- und Auslaßöffnungen 36 und 38 sind so gewählt, daß eine gute Aufbereitung mit flachen Strahlbildern in zwei Richtungen erfolgt.

Ebenso wie die Figur 24 zeigen die Figuren 25 bis 27 Lochscheiben 23 in der Draufsicht, mit denen Flachstrahlen erzeugbar sind. Als vereinfachte Zeichnungen zeigen diese Figuren nur den zentralen mittleren Bereich der Lochscheibe 23. Der Kanal 42' ist jeweils so ausgebildet, daß er die eine Einlaßöffnung 36 mit allen Auslaßöffnungen 38 verbindet. Das Fluid strömt durch die zentrale rechteckförmige Einlaßöffnung 36 ein. Die Auslaßöffnungen 38 sind beispielsweise ebenfalls mit einer rechteckigen oder quadratischen Kontur ausgebildet, wobei die Längserstreckungsrichtungen der rechteckigen Auslaßöffnungen 38 parallel oder senkrecht zur Längserstreckungsrichtung der Einlaßöffnung 36 sein können. Auf jeden Fall ergibt sich aus einem solchen Versatz wiederum ein flaches Strahlbild. Durch eine Variation der Größe der Einlaßöffnung 36, der Anordnung, der Anzahl und der Form der Auslaßöffnungen 38 kann die Strahlformgebung den jeweiligen Erfordernissen angepaßt werden.

Die Figur 28 zeigt eine Lochscheibe 23, die der in der Figur 24 dargestellten Lochscheibe 23 von der Geometrie und Größe der einzelnen Öffnungsbereiche stark ähnelt. Für besondere Anwendungszwecke, wie z.B. ungewöhnliche Einbaulagen von Einspritzventilen an Brennkraftmaschinen, ist nicht nur ein aus der Lochscheibe 23 austretender Flachstrahl wünschenswert, sondern ein Absprühen unter einem bestimmten Winkel zur Ventillängsachse/Mittelachse 2 (Figuren 1 und 3). Mit einer Lochscheibe 23 nach Figur 28 ist dies möglich. Eine jeweilige Funktionseinheit von Einlaßöffnung 36, Kanal 42 und Auslaßöffnung 38 ermöglicht wiederum einen Sprühkegel in Richtung des S-Schlages. Vier solcher Funktionseinheiten sind bei diesem Ausführungsbeispiel vorgesehen. Setzt man solche Sprühkegel bzw. Strahlkegel in geeigneter Weise zusammen, so kann das gesamte Strahlbild sehr gut den jeweiligen Gegebenheiten angepaßt werden. Mit der in der Figur 28 dargestellten Lochscheibe 23 kann gezielt in zwei Richtungen abgespritzt werden, wobei die beiden Einzelstrahlen nicht genau entgegengesetzt gerichtet sind.

In den Figuren 29 und 30 sind zentrale Abspritzbereiche von Lochscheiben 23 dargestellt, mit denen ebenfalls außergewöhnliche Strahlbilder erzeugbar sind. Die Lochscheiben 23 besitzen jeweils drei Funktionseinheiten mit einer Einlaßöffnung 36, einem Kanal 42 und einer Auslaßöffnung 38. Je nach gewünschtem Strahlbild sind die Funktionseinheiten asymmetrisch bzw. exzentrisch um die durch den Schnittpunkt der beiden Achsen 39 verlaufende Mittelachse 2 der Lochscheibe 23 angeordnet. Mit dieser scheinbar ungeordneten Aufteilung sind sehr gut individuelle Strahlrichtungen erzielbar. Bei der Lochscheibe nach Figur 29 verbindet jeweils ein Kanal 42 mit kreissektorförmiger Kontur eine kreisförmige Einlaßöffnung 36 mit einer sichelförmigen Auslaßöffnung 38. Dagegen sind die Öffnungsbereiche bei der Lochscheibe 23 in Figur 30 eckig ausgeführt. Das Fluid tritt durch z.B. quadratische Einlaßöffnungen 36 ein, strömt dann durch sechseckige Kanäle 42 bis zu Auslaßöffnungen 38, die rechteckig ausgebildet sind. Zwei Einlaßöffnungen 36 zugeordnete Kanäle 42 können z.B. so verlaufen, daß sie sich im Bereich der Auslaßöffnungen 38 vereinigen, wobei das Fluid dann auch nur noch über eine V-förmige Auslaßöffnung 38 aus der Lochscheibe 23 austritt. Die Anzahl der Ein- und Auslaßöffnungen 36 und 38 muß also keineswegs übereinstimmen.

Lochscheiben 23, bei denen Ein- und Auslaßöffnungen 36 und 38 nicht in gleicher Anzahl vorgesehen sind, zeigen auch die Figuren 31 bis 33. Das Ausführungsbeispiel in der Figur 31 verdeutlicht eine Anordnung mit durchweg kreisförmigen Öffnungsbereichen. Das Fluid kann über eine zentrale kreisförmige Einlaßöffnung 36 der oberen Schicht 35 eintreten und verläßt die Lochscheibe 23 über vier ebenfalls kreisförmige Auslaßöffnungen 38, die in der unteren Schicht 37 symmetrisch um die Einlaßöffnung 36 ausgebildet sind. Der eine kreisförmige Kanal 42' ist so groß gewählt, daß alle Auslaßöffnungen 38 von ihm vollständig überdeckt werden.

In der Figur 32 ist eine Lochscheibe 23 dargestellt, die vier Funktionseinheiten mit Öffnungsbereichen aufweist. Ein Fluid tritt über vier zu jeder Funktionseinheit gehörende und damit in der Summe über sechzehn sichelförmige Einlaßöffnungen 36 in die Lochscheibe 23 ein. Jeweils vier Einlaßöffnungen 36 ist genau ein kreisförmiger Kanal 42' zugeordnet, der beispielsweise einen solch großen Durchmesser besitzt, daß er die sichelförmigen Einlaßöffnungen 36 vollständig überdeckt. In jeder Funktionseinheit ist nur eine Auslaßöffnung 38 ausgeformt, die kreisförmig ausgeführt ist und in der Projektion von den sichelförmigen Einlaßöffnungen 36 umschlossen wird. Die vier Funktionseinheiten sind z.B. symmetrisch zur Mittelachse 2 auf den Achsen 39 liegend angeordnet.

In der Figur 33 ist eine Lochscheibe 23 gezeigt, die eine völlig asymmetrische Anordnung der Öffnungsbereiche aufweist. Die zentral angeordnete Einlaßöffnung 36 ist mit einer annähernd halbkreisförmigen Kontur ausgeformt, während sich die deutlich kleineren Auslaßöffnungen 38 sichelförmig auf der abgerundeten Seite der Einlaßöffnung 36 in der unteren Schicht 37 erstrecken. Die Anzahl der Auslaßöffnungen 38 kann beliebig variiert werden; im dargestellten Beispiel sind drei Auslaßöffnungen 38 vorgesehen. Der kreisförmige Kanal 42' ist wiederum so groß ausgeführt, daß alle anderen Öffnungen von ihm überdeckt werden.

Alle beschriebenen Lochscheiben 23 sind nicht ausschließlich für den Gebrauch an Einspritzventilen vorgesehen; sie können vielmehr auch z. B. bei Lackierdüsen, bei Inhalatoren, bei Tintenstrahldruckern oder bei Gefriertrockenverfahren zum Einsatz kommen. Zur Erzeugung feiner Sprays, z. B. mit großen Winkeln, eignen sich die Lochscheiben 23 ganz allgemein.

## Patentansprüche

1. Lochscheibe (23), insbesondere für Einspritzventile, mit einem vollständigen Durchgang für ein Fluid, mit wenigstens einer Einlaß- (36) und wenigstens einer Auslaßöffnung (38), die sich bei einer Projektion in eine Ebene an keiner Stelle überdecken, wobei jede Einlaßöffnung (36) in einer oberen Schicht (35) der Lochscheibe (23) und jede Auslaßöffnung (38) in einer unteren Schicht (37) der Lochscheibe (23) eingebracht ist, **dadurch gekennzeichnet, daß** wenigstens eine weitere mittlere Schicht (40, 40') zwischen der oberen Schicht (35) und der unteren Schicht (37) vorgesehen ist, die wenigstens einen Kanal (42, 42') aufweist, der eine vollständige Verbindung von wenigstens einer der Einlaßöffnungen (36) mit wenigstens einer der Auslaßöffnungen (38) darstellt und die aufeinanderliegenden Schichten (35, 37, 40, 40') der Lochscheibe (23) aufeinander galvanisch abgeschieden sind.

2. Lochscheibe nach Anspruch 1, **dadurch gekennzeichnet, daß** in wenigstens einer mittleren Schicht (40) eine der Anzahl der Einlaßöffnungen (36) und der Auslaßöffnungen (38) entsprechende Zahl an Kanälen (42) vorgesehen ist, so daß genau eine Einlaßöffnung (36) über einen Kanal (42) mit einer Auslaßöffnung (38) verbunden ist.

3. Lochscheibe nach Anspruch 1, **dadurch gekennzeichnet, daß** in wenigstens einer mittleren Schicht (40) ein Kanal (42') vorgesehen ist, mit dem alle Einlaßöffnungen (36) und alle Auslaßöffnungen (38) in Verbindung stehen.

4. Lochscheibe nach Anspruch 2, **dadurch gekennzeichnet, daß** die obere Schicht (35) eine Mehrzahl von Einlaßöffnungen (36) und die untere Schicht (37) eine Mehrzahl von Auslaßöffnungen (38) aufweist, wobei jeweils eine Einlaßöffnung (36) mit einer Auslaßöffnung (38) über einen Kanal (42) verbunden ist.

5. Lochscheibe nach einem der vorhergehenden Ansprüche, **dadurch gekennzeichnet, daß** die Einlaßöffnungen (36) näher zu einer Mittelachse (2) der Lochscheibe (23) ausgebildet sind als die Auslaßöffnungen (38), so daß ein radialer Versatz vorhanden ist.

6. Lochscheibe nach einem der vorhergehenden Ansprüche, **dadurch gekennzeichnet, daß** wenigstens eine der Einlaßöffnungen (36) eine andere öffnungsweite als eine der Auslaßöffnungen (38) besitzt.

7. Lochscheibe nach einem der vorhergehenden Ansprüche, **dadurch gekennzeichnet, daß** die Einlaßöffnungen (36) und die Auslaßöffnungen (38) vollständig symmetrisch um eine Mittelachse (2) der Lochscheibe (23) angeordnet sind.

8. Lochscheibe nach einem der vorhergehenden Ansprüche, **dadurch gekennzeichnet, daß** die Kanäle (42, 42') jeweils eine solche Größe haben, daß sie in der Projektion die Einlaßöffnungen (36) und die Auslaßöffnungen (38) vollständig überdecken.

9. Lochscheibe nach einem der vorhergehenden Ansprüche, **dadurch gekennzeichnet, daß** der wenigstens eine Kanal (42, 42') wenigstens einen Kanalfortsatz (43, 43') besitzt, der ein Gebiet darstellt, das sich nicht auf dem kürzesten Strömungsweg von den Einlaßöffnungen (36) zu den Auslaßöffnungen (38) befindet.

10. Lochscheibe nach Anspruch 9, **dadurch gekennzeichnet, daß** der wenigstens eine Kanalfortsatz (43) die gleiche Höhe wie der Kanal (42) aufweist.

11. Lochscheibe nach Anspruch 9, **dadurch gekennzeichnet, daß** der wenigstens eine Kanalfortsatz (43) in seiner Höhe und Breite das gleiche Abmaß besitzt.

12. Lochscheibe nach Anspruch 1, **dadurch gekennzeichnet, daß** die Lochscheibe (23) vierschichtig ausgebildet ist, wobei in der einen mittleren Schicht (40) der wenigstens eine Kanal (42, 42') verläuft und in der anderen mittleren Schicht (40') Kanalfortsätze (43') vorgesehen sind, die Gebiete darstellen, die sich nicht auf dem kürzesten Strömungsweg von den Einlaßöffnungen (36) zu den Auslaßöffnungen (38) befinden.

13. Lochscheibe nach Anspruch 1, **dadurch gekennzeichnet, daß** die Lochscheibe (23) fünfschichtig ausgebildet ist, wobei in einer der mittleren Schichten (40) der wenigstens eine Kanal (42, 42') verläuft und in den anderen beiden mittleren Schichten (40') Kanalfortsätze (43') vorgesehen sind, die Gebiete darstellen, die sich nicht auf dem kürzesten Strömungsweg von den Einlaßöffnungen (36) zu den Auslaßöffnungen (38) befinden.

14. Lochscheibe nach einem der Ansprüche 9, 12 oder 13, **dadurch gekennzeichnet, daß** die Kanalfortsätze (43, 43') in allen drei Richtungen, also in Länge, Breite und Tiefe vom Kanal (42, 42') ausgehend ausformbar sind.

15. Lochscheibe nach einem der vorhergehenden Ansprüche, **dadurch gekennzeichnet, daß** zumindest in eine mittlere Schicht (40, 40') hineinragend wenigstens eine Stolperfalle (50) angeordnet ist, durch die eine im Kanal (42, 42') vorbeistreichende Strömung eine Wirbelschleppe bildet.

16. Lochscheibe nach Anspruch 3, **dadurch gekennzeichnet, daß** die obere Schicht (35) eine Mehrzahl von Einlaßöffnungen (36) und die untere Schicht (37) eine Mehrzahl von Auslaßöffnungen (38) aufweist, die allesamt mit dem Kanal (42') in Verbindung stehen.

17. Lochscheibe nach Anspruch 1, **dadurch gekennzeichnet, daß** die Einlaßöffnungen (36) und die Auslaßöffnungen (38) in beliebiger Richtung zueinander versetzt sind.

18. Lochscheibe nach einem der vorhergehenden Ansprüche, **dadurch gekennzeichnet, daß** die Querschnitte der Einlaßöffnungen (36) denen der Auslaßöffnungen (38) von der Kontur her entsprechen.

19. Lochscheibe nach einem der Ansprüche 1 bis 17, **dadurch gekennzeichnet, daß** sich die Konturen der Querschnitte der Einlaßöffnungen (36) und der Auslaßöffnungen (38) voneinander unterscheiden.

20. Lochscheibe nach Anspruch 1, **dadurch gekennzeichnet, daß** die Querschnitte der Einlaßöffnungen (36) und der Auslaßöffnungen (38) Quadrate, Rechtecke, abgerundete Quadrate, abgerundete Rechtecke, Kreise, Kreissegmente, Ellipsen, Ellipsensegmente, Vielecke oder abgerundete Vielecke sind.

21. Lochscheibe nach Anspruch 1, **dadurch gekennzeichnet, daß** die Anzahl von Einlaß- (36) und Auslaßöffnungen (38) ungleich ist.

## Claims

1. Perforated disc (23), in particular for injection valves, having a complete passage for a fluid, having at least one inlet opening (36) and at least one outlet opening (38), which do not overlap at any point in a projection in a plane, each inlet opening (36) being placed in an upper layer (35) of the perforated disc (23) and each outlet opening (38) being placed in a lower layer (37) of the perforated disc (23), **characterized in that** at least one further middle layer (40, 40') is provided between the upper layer (35) and the lower layer (37), which middle layer has at least one channel (42, 42') which constitutes a complete connection of at least one of the inlet openings (36) to at least one of the outlet openings (38), and the layers (35, 37, 40, 40') of the perforated disc (23) which rest on one another are electro-deposited on one another.

2. Perforated disc according to Claim 1, **characterized in that** a number of channels (42) corresponding to the number of inlet openings (36) and outlet openings (38) is provided in at least one middle layer (40), with the result that exactly one inlet opening (36) is connected to one outlet opening (38) via a channel (42).

3. Perforated disc according to Claim 1, **characterized in that** a channel (42') is provided in at least one middle layer (40) and all of the inlet openings (36) and all of the outlet openings (38) are connected to it.

4. Perforated disc according to Claim 2, **characterized in that** the upper layer (35) has a plurality of inlet openings (36) and the lower layer (37) has a plurality of outlet openings (38), one inlet opening (36) in each case being connected to one outlet opening (38) via a channel (42).

5. Perforated disc according to one of the preceding claims, **characterized in that** the inlet openings (36) are formed closer to a central axis (2) of the perforated disc (23) than the outlet openings (38), with the result that there is a radial offset.

6. Perforated disc according to one of the preceding claims, **characterized in that** at least one of the inlet openings (36) has a different opening width than one of the outlet openings (38).

7. Perforated disc according to one of the preceding claims, **characterized in that** the inlet openings (36) and the outlet openings (38) are arranged in a completely symmetrical manner around a central axis (2) of the perforated disc (23).

8. Perforated disc according to one of the preceding claims, **characterized in that** the channels (42, 42') are in each case of such a size that they completely overlap the inlet openings (36) and the outlet openings (38) in the projection.

9. Perforated disc according to one of the preceding claims, **characterized in that** the at least one channel (42, 42') has at least one channel extension (43, 43') which constitutes an area which is not situated on the shortest flow path from the inlet openings (36) to the outlet openings (38).

10. Perforated disc according to Claim 9, **characterized in that** the at least one channel extension (43) is the same height as the channel (42).

11. Perforated disc according to Claim 9, **characterized in that** the at least one channel extension (43) has the same measurement in its height and width.

12. Perforated disc according to Claim 1, **characterized in that** the perforated disc (23) is of four-layered design, the at least one channel (42, 42') running in the one middle layer (40), and in the other middle layer (40') there being provided channel extensions (43') which constitute areas which are not situated on the shortest flow path from the inlet openings (36) to the outlet openings (38).

13. Perforated disc according to Claim 1, **characterized in that** the perforated disc (23) is of five-layered design, the at least one channel (42, 42') running in one of the middle layers (40), and in the other two middle layers (40') there being provided channel extensions (43') which constitute areas which are not situated on the shortest flow path from the inlet openings (36) to the outlet openings (38).

14. Perforated disc according to one of Claims 9, 12 or 13, **characterized in that** the channel extensions (43, 43') can be formed emanating in all three directions, i.e. in length, width and depth, from the channel (42, 42').

15. Perforated disc according to one of the preceding claims, **characterized in that** there is arranged at least one shoulder-like trap which protrudes at least into a middle layer (40, 40') and causes a flow brushing past in the channel (42, 42') to form an eddying tail.

16. Perforated disc according to Claim 3, **characterized in that** the upper layer (35) has a plurality of inlet openings (36) and the lower layer (37) has a plurality of outlet openings (38), which openings are all connected to the channel (42').

17. Perforated disc according to Claim 1, **characterized in that** the inlet openings (36) and the outlet openings (38) are offset with respect to one another in any desired direction.

18. Perforated disc according to one of the preceding claims, **characterized in that** the cross sections of the inlet openings (36) correspond in terms of contour to those of the outlet openings (38).

19. Perforated disc according to one of Claims 1 to 17, **characterized in that** the contours of the cross sections of the inlet openings (36) and of the outlet openings (38) differ from one another.

20. Perforated disc according to Claim 1, **characterized in that** the cross sections of the inlet openings (36) and of the outlet openings (38) are squares, rectangles, rounded squares, rounded rectangles, circles, segments of a circle, ellipses, segments of an ellipse, polygons or rounded polygons.

21. Perforated disc according to Claim 1, **characterized in that** the number of inlet openings (36) and outlet openings (38) differs.

## Revendications

1. Disque perforé (23) notamment pour un injecteur comportant un passage total pour un liquide avec au moins un orifice d'entrée (36) et au moins un orifice de sortie (38) qui ne se chevauche à aucun endroit en projection dans un plan,
chaque orifice d'entrée (36) étant réalisé dans une couche supérieure (37) du disque perforé (23) et chaque orifice de sortie (38) dans une couche inférieure (37) du disque perforé (23),
**caractérisé en ce que**
au moins une autre couche (40, 40') est prévue entre la couche supérieure (35) et la couche inférieure (37), cette couche intermédiaire ayant au moins un canal (42, 42') qui constitue une liaison totale entre au moins l'un des orifices d'entrée (36) et au moins l'un des orifices de sortie (38) et les couches superposées (35, 37, 40, 40') du disque perforé (23) sont déposées galvaniquement l'une sur l'autre.

2. Disque perforé selon la revendication 1,
**caractérisé en ce que**
dans au moins une couche intermédiaire (40) on a un nombre de canaux (42) qui correspond au nombre d'orifices d'entrée (36) et d'orifices de sortie (38) de façon à ce que précisément un orifice d'entrée (36) soit relié par un canal (42) et un orifice de sortie (38).

3. Disque perforé selon la revendication 1,
**caractérisé en ce qu'**
au moins une couche intermédiaire (40) comporte un canal (42') avec lequel communique tous les orifices d'entrée (36) et tous les orifices de sortie (38).

4. Disque perforé selon la revendication 2,
**caractérisé en ce que**
la couche supérieure (35) comporte plusieurs orifices d'entrée (36) et la couche inférieure (37) plusieurs orifices de sortie (38), chaque orifice d'entrée (36) étant relié à un orifice de sortie (38) par un canal (42).

5. Disque perforé selon l'une quelconque des revendications précédentes,
**caractérisé en ce que**
les orifices d'entrée (36) sont plus prêt de l'axe central (2) du disque perforé (23) que les orifices de sortie (38) avec un décalage radial.

6. Disque perforé selon l'une quelconque des revendications précédentes,
**caractérisé en ce qu'**
au moins l'un des orifices d'entrée (36) a une autre dimension d'ouverture que l'un des orifices (38).

7. Disque perforé selon l'une quelconque des revendications précédentes,
**caractérisé en ce que**
les orifices d'entrée (36) et les orifices de sortie (38) sont répartis de manière totalement symétrique autour de l'axe central (2) du disque perforé (23).

8. Disque perforé selon l'une quelconque des revendications précédentes,
**caractérisé en ce que**
les canaux (42, 42') ont des dimensions telles qu'en projection ils couvrent complètement les orifices d'entrée (36) et les orifices de sortie (38).

9. Disque perforé selon l'une quelconque des revendications précédentes,
**caractérisé en ce qu'**
au moins un canal (42, 42') possède au moins un prolongement de canal (43, 43') qui représente une zone qui ne se trouve pas sur le chemin de passage le plus court entre les orifices d'entrée (36) et les orifices de sortie (38).

10. Disque perforé selon la revendication 9,
**caractérisé en ce qu'**
au moins un prolongement de canal (43) possède la même hauteur que le canal (42).

11. Disque perforé selon la revendication 9,
**caractérisé en ce qu'**
au moins un prolongement de canal (43) a une hauteur et une largeur de même dimension.

12. Disque perforé selon la revendication 1,
**caractérisé en ce que**
le disque perforé (23) est à quatre couches, et une couche intermédiaire (40) traversée par au moins un canal (42, 42') et l'autre couche intermédiaire (40') comportent le prolongement de canal (43') qui constitue des zones qui ne se trouvent pas sur le chemin de passage le plus court entre les orifices d'entrée (36) et les orifices de sortie (38).

13. Disque perforé selon la revendication 1,
**caractérisé en ce que**
le disque perforé (23) a cinq couches et l'une des couches intermédiaires (40) est traversée par au moins un canal (42, 42') et l'autre des deux couches intermédiaires (40') comporte les prolongements de canal (43') qui représentent des zones qui ne se trouvent pas sur le chemin de passage le plus court entre les orifices d'entrée (36) et les orifices de sortie (38).

14. Disque perforé selon l'une des revendications 9, 12, 13,
**caractérisé en ce que**
les prolongements de canal (43, 43') partent dans les trois directions c'est-à-dire la longueur, la largeur et la profondeur à partir du canal (42, 42').

15. Disque perforé selon l'une quelconque des revendications précédentes,
**caractérisé en ce qu'**
au moins dans la couche intermédiaire (40, 40') on a une butée d'écoulement (50) venant en saillie pour former une traînée de turbulence dans l'écoulement qui passe sur cette butée dans le canal (42, 42').

16. Disque perforé selon la revendication 3,
**caractérisé en ce que**
la couche supérieure (35) comporte plusieurs orifices d'entrée (36) et la couche inférieure (37) plusieurs orifices de sortie (38) tous reliés au canal (42').

17. Disque perforé selon la revendication 1,
**caractérisé en ce que**
les orifices d'entrée (36) et les orifices de sortie (38) sont décalés les uns par rapport aux autres dans des directions quelconques.

18. Disque perforé selon l'une quelconque des revendications précédentes,
**caractérisé en ce que**
la section des orifices d'entrée (36) correspond par le contour à celle des orifices de sortie (38).

19. Disque perforé selon l'une des revendications 1 à 17,
**caractérisé en ce que**
les contours des sections des orifices d'entrée (36) et des orifices de sortie (38) sont différents.

20. Disque perforé selon la revendication 1,
**caractérisé en ce que**
la section des orifices d'entrée (36) et celle des orifices de sortie (38) sont des carrés, des rectangles, des carrés arrondis, des rectangles arrondis, des cercles, des segments de cercles, des ellipses, des segments d'ellipses, des polygones ou des polygones arrondis.

21. Disque perforé selon la revendication 1,
**caractérisé en ce que**
le nombre des orifices d'entrée (36) et celui des orifices de sortie (38) est différent.
